# EUROPÄISCHE PATENTSCHRIFT

(11) **EP 2 742 561 B1**
(45) Veröffentlichungstag und Bekanntmachung des Hinweises auf die Patenterteilung: **21.12.2016**
(21) Anmeldenummer: 12743127.8
(22) Anmeldetag: 26.07.2012
(51) Int. Cl.: H01R 9/26, H05K 7/14

(54) **MODULARE STEUERVORRICHTUNG**
MODULAR CONTROL DEVICE
SYSTÈME DE CONTRÔLE MODULAIRE

(30) Priorität: 09.08.2011 DE 102011110184
(43) Veröffentlichungstag der Anmeldung: 18.06.2014
(73) Patentinhaber: Pilz GmbH & Co. KG, 73760 Ostfildern (DE)
(72) Erfinder: CECH, Markus, 73760 Ostfildern (DE); VEIT, Andreas, 73760 Ostfildern (DE); HEWER, Patrick, 73760 Ostfildern (DE); GODAU, Thorsten, 73760 Ostfildern (DE)
(74) Vertreter: Witte, Weller & Partner Patentanwälte mbB
(86) Internationale Anmeldenummer: PCT/EP2012/064683
(87) Internationale Veröffentlichungsnummer: WO 2013/020818

(56) Entgegenhaltungen:
- EP-A2- 0 909 122
- WO-A1-2012/000808
- DE-U1- 29 713 960
- DE-U1-202010 004 408
- US-A- 5 253 140
- Anonymous: "X20 System Anwenderhandbuch - Version: 2.10 (März 2009) - Kapitel 6 "Mechanisches Handling"", , 1. März 2009 (2009-03-01), Seiten 1115-1144, XP55041598, Gefunden im Internet: URL:http://www.br-automation.com/cps/rde/x chg/br-productcatalogue/hs.xsl/services_13 3603_DEU_HTML.htm [gefunden am 2012-10-19] in der Anmeldung erwähnt

## Beschreibung

Die vorliegende Erfindung betrifft eine Steuerungsvorrichtung zum automatisierten Steuern einer technischen Anlage. Die Steuerungsvorrichtung hat zumindest ein Modul, das zumindest ein erstes Modulteil und ein zweites Modulteil umfasst. Das erste Modulteil und das zweite Modulteil können mechanisch und elektrisch in eine zusammengesetzte Anordnung zusammengesetzt werden. Das erste Modulteil und das zweite Modulteil umfassen jeweils ein Gehäuse mit jeweils einer Grenzfläche. Die Grenzflächen liegen sich in der zusammengesetzten Anordnung derart gegenüber, dass eine Grenzebene definiert ist. Das erste Modulteil weist ein Schwenkhalterungselement auf, an dem das zweite Modulteil lösbar gehalten werden kann. Das Schwenkhalterungselement definiert einen Schwenkpunkt mit einer Schwenkachse, so dass das erste Modulteil und das zweite Modulteil durch eine Schwenkbewegung entlang einer definierten Bewegungsbahn in die zusammengesetzte Anordnung zusammengesetzt werden können. Durch die Schwenkachse ist eine auf der Schwenkachse liegende, senkrecht zur Grenzebene angeordnete Schwenkachsenebene definiert. Eines der Modulteile umfasst eine Anzahl von Kontakten mit einem ersten elektrischen Kontakt und das andere Modulteil umfasst eine Anzahl von Gegenkontakten mit einem ersten elektrischen Gegenkontakt, der in der ersten zusammengesetzten Anordnung den ersten elektrischen Kontakt kontaktiert zur elektrischen Verbindung zwischen dem ersten und dem zweiten Modulteil. Die Kontakte und die Gegenkontakte sind in einer Kontaktebene, die senkrecht zur Schwenkachse verläuft, angeordnet. Die Kontakte sind jeweils eine Leiterbahn auf einer nichtleitenden Platte, so dass eine Leiterplatte gebildet wird.

Die Erfindung betrifft ferner ein Modul oder Modulteil für eine solche Steuerungsvorrichtung.

Eine Steuerungsvorrichtung und ein Modul bzw. ein Modulteil dieser Art sind aus DE 297 13 960 U1 bekannt.

Eine Steuerungsvorrichtung im Sinne der vorliegenden Erfindung kann beispielsweise eine modulare Steuerungsvorrichtung für eine konfigurierbare oder programmierbare Steuerung sein. Es kann eine konfigurierbare Steuerung sein, wie beispielsweise jene, die die Anmelderin der vorliegenden Erfindung unter der Marke PNOZ® vertreibt, oder eine programmierbare Steuerung, wie beispielsweise jene die die Anmelderin unter der Marke PSS® vertreibt, oder eine dieser ähnliche. Unter konfigurierbar ist hier das Anpassen oder Einstellen eines Hardwarebestandteils der Steuerung zu verstehen, wie beispielsweise einer Verdrahtung. Unter programmierbar ist hier das Anpassen oder Einstellen eines Softwarebestandteils der Steuerung zu verstehen, beispielsweise mittels einer Programmiersprache.

Insbesondere stellt PSSuniversal® eine modulare programmierbare Steuerungsvorrichtung für Standard- und Sicherheitsaufgaben bereit, wie aus der Beschreibung "Pilz, PSSuniversal, Programmable Control Systems PSS®, System Description, No. 21256-EN-04" bekannt. Ein Modul umfasst hier ein erstes Modulteil in Form eines Elektronikmodulteils und ein zweites Modulteil in Form eines Basismodulteils, oder im Folgenden auch Busmodulteil genannt. Das Elektronikmodulteil wird durch eine lineare Bewegung auf das Busmodulteil gesteckt.

Eine Steuerungsvorrichtung im Sinne der vorliegenden Erfindung kann aber auch eine Steuerungsvorrichtung mit einem Modul mit drei Modulteilen sein. Eine solche ist beispielsweise durch das X20-System von B&R bekannt, wie aus der Beschreibung "X20-System, User's Manual, Version: 2.10 (May 2009), Model Number: MAX20-ENG" ersichtlich. Ein Modul umfasst hier ein erstes Modulteil in Form eines Elektronikmodulteils, ein zweites Modulteil in Form eines Busmodulteils und ein drittes Modulteil in Form eines Feldklemmenmodulteils, oder auch Anschlussmodulteil genannt. Die externen Anschlüsse sind in diesem System in einem separaten Anschlussmodulteil untergebracht. Das Anschlussmodulteil kann durch eine Schwenkbewegung auf das Elektronikmodulteil aufgesetzt werden.

Die Eingangs genannte DE 297 13 960 U1 beschreibt ein elektrisches oder elektronisches Gerät zum Aufsetzen auf eine Tragschiene, mit einem Gehäuse, mit wenigstens einer im Gehäuse angeordneten Leiterplatte und mit in Tragschienenlängsrichtung weisenden Buskontakten für eine Daten- und/oder Energiebusverbindung mit benachbarten, auf die Tragschiene aufgesetzten und korrespondierende Buskontakte aufweisenden elektrischen oder elektronischen Geräten. Das Gehäuse ist zumindest zweiteilig ausgebildet. Es sind ein die Leiterplatte aufnehmendes Oberteil und ein die Buskontakte aufweisendes Sockelteil mit einer Leiterplattenaufnahme vorgesehen. Das Oberteil kann auf das Sockelteil aufschwenkbar sein.

Ein Problem solcher Steuerungsvorrichtungen mit schwenkbaren Modulteilen kann sein, dass es bei kleinerer Bauform zu Kontaktierungsfehlern kommen kann, wenn die Modulteile durch Schwenkbewegung zusammengesetzt werden.

Vor diesem Hintergrund ist es eine Aufgabe der vorliegenden Erfindung, eine Steuerungsvorrichtung und ein Modul bzw. Modulteil der eingangs genannten Art anzugeben, die bei zunehmender Miniaturisierung bzw. kleinerer Bauform Kontaktierungsfehler bzw. Fehlkontaktierungen, und somit möglicherweise Kurzschlüsse, vermeidet.

Gemäß einem Aspekt der Erfindung wird diese Aufgabe durch eine Steuerungsvorrichtung der eingangs genannten Art gelöst, wobei der erste elektrische Kontakt eine durch eine Außenkontur begrenzte freiliegende Kontaktfläche mit einem in der Bewegungsbahn vorlaufendem Ende aufweist, wobei die erste Außenkontur in der zusammengesetzten Anordnung zumindest am vorlaufenden Ende zumindest einen zur Schwenkachsenebene hin geneigten Abschnitt umfasst.

Die Aufgabe wird gemäß einem weiteren Aspekt der Erfindung durch ein erstes Modulteil gemäß Anspruch 15 gelöst.

Das eine Modulteil umfasst eine Anzahl von elektrischen Kontakten, und das andere Modulteil umfasst eine Anzahl von entsprechenden elektrischen Gegenkontakten. In der zusammengesetzten Anordnung kontaktiert jeder Kontakt seinen entsprechenden Gegenkontakt zur elektrischen Verbindung zwischen den Modulteilen. Es sind so komplexe Kontaktierungen möglich. Beispielsweise können somit mehrere Anschlüsse bzw. Eingänge und/oder Ausgänge bereitgestellt werden. Jeder der Anzahl von Kontakten weist eine durch eine Außenkontur begrenzte freiliegende Kontaktfläche mit einem in der Bewegungsbahn verlaufenden Ende auf. Ein Teil oder jeder der Kontakte hat eine Außenkontur, die den geneigten Abschnitt umfasst. Die Kontakte bzw. Gegenkontakte können insbesondere nebeneinander liegend in einer Reihe angeordnet sein.

Eine Fehlkontaktierung tritt insbesondere dann auf, wenn ein erster Kontakt im Verlauf der Schwenkbewegung einen zweiten Gegenkontakt, der einem neben dem ersten Kontakt liegenden (in radialer Richtung, ausgehend vom Schwenkpunkt) zweiten Kontakt zugeordnet ist (und nicht dem ersten Kontakt zugeordnet), kontaktiert. Die Kontakte und/oder die Gegenkontakte sind hierbei insbesondere in einer Kontaktebene, die senkrecht zur Schwenkachse verläuft, nebeneinander angeordnet. Es wurde erkannt, dass eine derartige Fehlkontaktierung abhängig vom radialen Abstand des jeweiligen (ersten) Kontakts zum Schwenkpunkt und vom Abstand zwischen den Kontakten ist. Dadurch, dass das vorlaufende Ende der Kontaktfläche des jeweiligen (ersten) Kontakts zumindest ein zur Schwenkachsenebene (senkrecht zur Grenzebene angeordnete und durch die Schwenkachse definierte Ebene) hin geneigten Abschnitt umfasst, wird vermieden, dass die Kontaktfläche im Verlauf der Schwenkbewegung den (zweiten) Gegenkontakt, der dem neben dem jeweiligen (ersten) Kontakt liegenden (zweiten) Kontakt zugeordnet ist, kontaktiert. Die Außenkontur der freiliegenden Kontaktfläche ist an die Schwenkbewegung angepasst. Unter freiliegender Kontaktfläche ist insbesondere die nach außen hin freiliegende bzw. kontaktierbare elektrisch leitfähige Fläche zu verstehen. Bei kleiner Bauform, insbesondere kleinem Abstand zwischen den Kontakten bzw. Kontaktflächen und/oder kleinem radialen Abstand zum Schwenkpunkt, können somit Kontaktierungsfehler bzw. Fehlkontaktierungen, und somit möglicherweise Kurzschlüsse, verhindert werden. Es wird eine sehr präzise Kontaktierung ermöglicht.

Insgesamt ermöglichen die neue Steuerungsvorrichtung und das neue Modul bzw. Modulteil daher bei kleiner Bauform Kontaktierungsfehler bzw. Fehlkontaktierungen, und somit möglicherweise Kurzschlüsse, zu vermeiden. Die oben genannte Aufgabe ist daher vollständig gelöst.

In einer weiteren Ausgestaltung befindet sich der geneigte Abschnitt zumindest in dem Bereich des vorlaufenden Endes der ersten Außenkontur, der den größten radialen Abstand zum Schwenkpunkt aufweist.

In dieser Ausgestaltung muss nicht die gesamte Außenkontur der Kontaktfläche angepasst werden, sondern nur ein kritischer Bereich. Insbesondere kann nur der kritische Bereich der Außenkontur den geneigten Abschnitt aufweisen. Der kritische Bereich ist der Bereich des vorlaufenden Endes der ersten Außenkontur, der den größten radialen Abstand zum Schwenkpunkt aufweist.

In einer weiteren Ausgestaltung umfasst der geneigte Abschnitt zumindest eine Gerade oder Krümmung.

In dieser Ausgestaltung wird eine besonders geeignete und/oder einfache Realisierung des geneigten Abschnitts bereitgestellt.

In einer weiteren Ausgestaltung ist die erste Außenkontur eine vierseitige oder fünfseitige Außenkontur.

In dieser Ausgestaltung kann von einer konventionellen rechteckigen Außenkontur ausgegangen werden, die derart angepasst wird, dass sie den geneigten Abschnitt umfasst. Die Realisierung des geneigten Abschnitts ist somit einfach.

In einer weiteren Ausgestaltung ist der geneigte Abschnitt eine die Gerade umfassende gerade Seite der vierseitigen oder fünfseitigen Außenkontur. In einer Variante dieser Ausgestaltung umfasst der geneigte Abschnitt bzw. die erste Außenkontur zwei parallel zueinander verlaufende (geneigte) Seiten.

In dieser Ausgestaltung kann bei einer vierseitigen (z.B. konventionellen rechteckigen) Außenkontur die Außenkontur bzw. Kontaktfläche einfach schräg angeordnet werden. Bei einer fünfseitigen Außenkontur kann ausgehend von einer vierseitigen (z.B. konventionellen rechteckigen) Außenkontur einfach eine Ecke abgeschrägt werden. Insbesondere kann die gerade geneigte Seite einen bestimmten Winkel in Bezug auf die Schwenkachsenebene aufweisen.

In einer weiteren Ausgestaltung ist der geneigte Abschnitt eine die Krümmung umfassende gekrümmte Seite der vierseitigen oder fünfseitigen Außenkontur. In einer Variante dieser Ausgestaltung umfasst die erste Außenkontur zwei parallel zueinander verlaufende gekrümmte Seiten.

In dieser Ausgestaltung ist eine optimale Anpassung an die ebenfalls gekrümmt verlaufende Bewegungsbahn der Schwenkbewegung möglich.

In einer weiteren Ausgestaltung weist die erste Kontaktfläche eine Anzahl von voneinander isolierten Kontaktflächen auf.

In dieser Ausgestaltung kann die gewünschte Außenkontur durch eine Anzahl kleinerer Kontaktflächen bereitgestellt werden. Die Außenkontur ist somit sehr variabel anpassbar.

In einer weiteren Ausgestaltung umfasst das Modulteil mit dem ersten Gegenkontakt weiterhin einen in auswärtiger radialer Richtung neben dem ersten Gegenkontakt liegenden zweiten elektrischen Gegenkontakt, der eine durch eine zweite Außenkontur begrenzte freiliegende Kontaktfläche aufweist. Jeder Punkt der ersten und der zweiten Außenkontur weist während der Schwenkbewegung einen bestimmten radialen Abstand zum Schwenkpunkt auf. Jeder Punkt der ersten Außenkontur weist einen radialen Abstand auf, der kleiner ist als ein radialer Abstand eines Punktes der zweiten Außenkontur, der von den Punkten der zweiten Außenkontur den kleinsten radialen Abstand aufweist.

In dieser Ausgestaltung wird verhindert, dass der erste Kontakt im Verlauf der Schwenkbewegung einen zweiten Gegenkontakt kontaktiert, der neben dem ersten Gegenkontakt liegt. Der zweite Gegenkontakt ist einem zweiten Kontakt zugeordnet, der in auswärtiger radialer Richtung (ausgehend vom Schwenkpunkt) neben dem ersten Kontakt liegt, und ist nicht dem ersten Kontakt zugeordnet.

In einer weiteren Ausgestaltung verändern sich die geneigten Abschnitte der Außenkonturen der Kontakte mit zunehmendem radialen Abstand zwischen Kontakt und Schwenkpunkt.

In dieser Ausgestaltung wird eine noch genauere Kontaktierung bereitgestellt durch eine noch genauere Anpassung an die Schwenkbewegung. Die exakte Position eines jedes Kontaktes in Bezug auf den Schwenkpunkt wird berücksichtigt. Die Änderung ist an die Schwenkbewegung angepasst. Insbesondere verändern sich geneigten Abschnitte derart, dass die geneigten Abschnitte bzw. die Außenkonturen an die Schwenkbewegung angepasst sind. Insbesondere kann sich die Außenkontur, oder der Winkel einer geraden geneigten Seite, in Bezug auf die Schwenkachsenebene mit zunehmendem radialem Abstand zwischen Kontakt und Schwenkpunkt verändern.

In einer weiteren Ausgestaltung sind das erste Modulteil und das zweite Modulteil derart ausgebildet, dass ein letzter Kontakt der Anzahl von Kontakten beim Zusammensetzen als letzter Kontakt mit dem entsprechenden Gegenkontakt schließt. Der letzte Kontakt ist insbesondere der Kontakt mit dem größten radialen Abstand zum Schwenkpunkt.

In dieser Ausgestaltung kann eine bestimmte Schließreihenfolge der Kontakte definiert werden. Es wird erreicht, dass diese Schließreihenfolge durch die definierte Bewegungsbahn der Schwenkbewegung um die Schwenkachse stets eingehalten wird. Insbesondere können die freiliegenden Kontaktflächen alle denselben Abstand zur Grenzfläche des Modulteils aufweisen.

In einer weiteren Ausgestaltung besitzt die Steuerungsvorrichtung oder das Modul einen Ausgang zum Ausgeben eines Signals, das die Betriebsbereitschaft der Steuerungsvorrichtung oder des Moduls anzeigt, wenn beim Zusammensetzen der letzten Kontakt schließt.

In dieser Ausgestaltung wird eine sichere Erkennung des zusammengesetzten (bzw. betriebsbereiten) Zustands des Moduls erreicht, durch Berücksichtigung der bestimmten Schließreihenfolge der Kontakte.

In einer weiteren Ausgestaltung umfasst das zweite Modulteil eine Aussparung, in die das Schwenkhalterungselement des ersten Modulteils eingreifen kann, so dass das zweite Modulteil lösbar gehalten ist. Das Schwenkhalterungselement kann insbesondere ein Vorsprung (z.B. gekrümmter Vorsprung oder ähnliches) sein, der in die Aussparung eingreift.

In dieser Ausgestaltung wird gewährleistet, dass eine fest definierte (saubere) Schwenkbewegung um einen fest definierten Schwenkpunkt erfolgt. Es wird so das Risiko von Fehlkontaktierungen noch weiter verringert.

In einer weiteren Ausgestaltung umfasst zumindest ein Modul zumindest das erste Modulteil, das zweite Modulteil, und ein drittes Modulteil. Das erste Modulteil und das zweite Modulteil können mechanisch und elektrisch in eine erste zusammengesetzte Anordnung zusammengesetzt werden. Das erste Modulteil und das dritte Modulteil können mechanisch und elektrisch in eine zweite zusammengesetzte Anordnung zusammengesetzt werden.

In einer weiteren Ausgestaltung umfasst das erste Modulteil eine Signalverarbeitungseinheit. Alternativ oder kumulativ umfasst das zweite Modulteil zumindest einen Busanschluss für einen Kommunikationsbus oder Versorgungsspannungsbus. Weiterhin alternativ oder kumulativ umfasst das dritte Modulteil zumindest einen externen Anschluss zum Anlegen eines Signals oder einer Spannung.

In dieser Ausgestaltung kann eine optimale Verteilung von unterschiedlichen Funktionen auf die drei Modulteile bereitgestellt werden. Insbesondere kann hiermit dem ersten Modulteil die Funktion eines Elektronikmodulteils, dem zweiten Modulteil die Funktion eines Busmodulteils, und dem dritten Modulteil die Funktion eines Anschlussmodulteils zugewiesen werden.

In einer weiteren Ausgestaltung weist das erste Modulteil zwei redundante Signalverarbeitungskanäle auf, um zumindest ein Eingangssignal redundant zueinander zu verarbeiten. Die zwei redundanten Signalverarbeitungskanäle können jeweils in der Lage sein, logische Signalverknüpfungen vorzunehmen, um in Abhängigkeit davon ein Signal zu erzeugen. Dieses Signal kann bevorzugt verwendet werden, um ein Schaltelement zum Abschalten der technischen Anlage anzusteuern. Das zumindest eine Eingangssignal kann ein Signal sein, das an dem externen Anschluss des dritten Modulteils anliegt. Bevorzugt verarbeiten die zwei Signalverarbeitungskanäle zwei Eingangssignale redundant zueinander. Jedes der zwei Eingangssignale kann dann ein Signal sein, das an jeweils einem externen Anschluss des dritten Modulteils anliegt.

In dieser Ausgestaltung führt das entsprechende Modul bzw. Modulteil Sicherheitsaufgaben oder Sicherheitsfunktionen aus. Insbesondere kann hier das entsprechende Modul bzw. Modulteil zum fehlersicheren (FS) Abschalten der technischen Anlage verwendet werden.

In einer weiteren Ausgestaltung ist der erste Gegenkontakt ein Kontaktelement, das in einem Stecker oder Buchse angeordnet ist. Alternativ oder kumulativ sind die Gegenkontakte Kontaktelemente, die nebeneinanderliegend in einem Stecker oder Buchse angeordnet sind. Insbesondere kann in den Stecker oder die Buchse die Leiterplatte eingeführt werden. Es wird somit eine Steckverbindung gebildet. Insbesondere ist in der ersten zusammengesetzten Anordnung die Leiterplatte in den Stecker oder die Buchse eingeführt. So kann jeder Kontakt seinen entsprechenden Gegenkontakt kontaktieren zur elektrischen Verbindung zwischen dem ersten und zweiten Modulteil.

In einer weiteren Ausgestaltung verlaufen die Gegenkontakte in ihrer Längsrichtung parallel zur Schwenkachsenebene. Die Gegenkontakte bzw. die Außenkonturen ihrer freiliegenden Kontaktflächen weisen also keinen geneigten Abschnitt auf. Somit kann weiterhin ein konventioneller Stecker oder Buchse für die Gegenkontakte verwendet werden.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Fig. 1: eine vereinfachte Darstellung einer technischen Anlage mit einem Ausführungsbeispiel der Steuerungsvorrichtung,
- Fig. 2: eine perspektivische Darstellung eines Ausführungsbeispiels der Steuervorrichtung mit mehreren nebeneinander angeordneten Modulen mit ersten Modulteilen und zweite Modulteilen,
- Fig. 3: eine perspektivische Darstellung des Ausführungsbeispiels der Steuervorrichtung nach Fig. 2 mit nur zweiten Modulteilen,
- Fig. 4: eine perspektivische Darstellung eines ersten Ausführungsbeispiels eines Moduls mit einem ersten, zweiten und dritten Modulteil in einer ersten und zweiten zusammengesetzten Anordnung,
- Fig. 4a: eine Querschnittsansicht des in Fig. 4 gezeigten Moduls,
- Fig. 5: eine perspektivische Darstellung des ersten Ausführungsbeispiels des Moduls der Fig. 4 in einem Zustand, in dem das dritte Modulteil gelöst wird,
- Fig. 5a: eine Querschnittsansicht des in Fig. 5 gezeigten Moduls,
- Fig. 6: eine Querschnittsansicht des ersten Ausführungsbeispiels des Moduls der Fig. 4 bis 5 in einem Zustand, in dem das erste Modulteil gelöst wird,
- Fig. 6a: einen ersten vergrößerten Bereich X der Querschnittsansicht der Fig. 6,
- Fig. 6b: einen zweiten vergrößerten Bereich Y der Querschnittsansicht der Fig. 6,
- Fig. 7a- c: jeweils eine Kontaktfläche, deren Außenkontur einen geneigten Abschnitt mit zumindest einer Krümmung umfasst,
- Fig. 8: eine Querschnittsansicht eines ersten Modulteils einer Variante des ersten Ausführungsbeispiels des Moduls,
- Fig. 8a: einen vergrößerten Bereich X der Querschnittsansicht der Fig. 8,
- Fig. 9, 10: jeweils eine Kontaktfläche, deren Außenkontur einen geneigten Abschnitt mit zumindest einer Geraden umfasst,
- Fig. 11a-b: jeweils eine Kontaktfläche mit einer Anzahl von voneinander isolierten Kontaktflächen,
- Fig. 12: eine Querschnittsansicht eines Ausschnitts eines ersten Modulteils und eines zweiten Modulteils nach einem Ausführungsbeispiel, in einem Zustand, in dem das erste Modulteil durch Schwenkbewegung aufgesetzt wird, und
- Fig. 13.: eine Querschnittsansicht eines Ausschnitts eines ersten Modulteils und eines zweiten Modulteils nach einem anderen Ausführungsbeispiel, in einem Zustand, in dem das erste Modulteil durch Schwenkbewegung aufgesetzt wird.

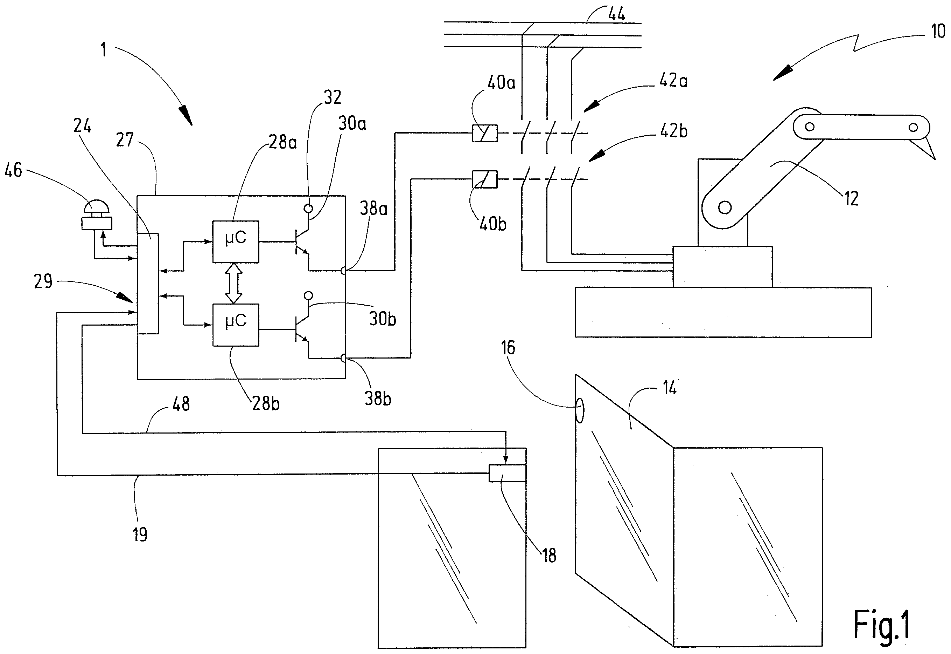

In Fig. 1 ist eine technische Anlage 10 mit einem Ausführungsbeispiel der neuen Steuerungsvorrichtung 1 zum automatisierten Steuern der technischen Anlage 10 dargestellt. In diesem Ausführungsbeispiel ist die Steuerungsvorrichtung 1 geeignet zum fehlersicheren Abschalten der Anlage 10, d.h. die Steuerungsvorrichtung 1 wird für Sicherheitsaufgaben verwendet. Die Anlage 10 beinhaltet hier beispielhaft einen Roboter 12, von dessen Bewegungen im Arbeitsbetrieb eine Gefahr für Personen ausgeht, die sich im Arbeitsbereich des Roboters 12 aufhalten. Aus diesem Grund ist der Arbeitsbereich des Roboters 12 mit einem Schutzzaun mit einer Schutztür 14 abgesichert. Die Schutztür 14 ermöglicht den Zugang in den Arbeitsbereich des Roboters 12, beispielsweise für Wartungsarbeiten oder für Einrichtarbeiten. Im normalen Arbeitsbetrieb darf der Roboter 12 jedoch nur arbeiten, wenn die Schutztür 14 geschlossen ist. Sobald die Schutztür 14 geöffnet wird, muss der Roboter 12 abgeschaltet werden oder auf andere Weise in einen sicheren Zustand gebracht werden.

Um den geschlossenen Zustand der Schutztür 14 zu detektieren, ist an der Schutztür 14 ein Schutztürschalter mit einem Türteil 16 und einem Rahmenteil 18 angebracht. Das Rahmenteil 18 erzeugt auf einer Leitung 20 ein Schutztürsignal, das über die Leitung 20 der neuen Steuerungsvorrichtung 1 zugeführt ist.

Die Steuerungsvorrichtung 1 besitzt in diesem Ausführungsbeispiel einen E/A-Teil 24 mit einer Vielzahl von Anschlüssen (bzw. externen oder Geräteanschlüssen) 29. In einigen Ausführungsbeispielen sind die Anschlüsse 29 Anschlussklemmen oder Feldklemmen, die an einer Gehäuseseite des Gehäuses 27 der Steuerungsvorrichtung 1 angeordnet sind, beispielsweise an einem Anschlussmodulteil, wie im Folgenden erklärt werden wird. Beispielsweise kann es sich um Federzugklemmen oder um Schraubklemmen handeln. In anderen Ausführungsbeispielen können die Anschlüsse Stecker oder Buchsen sein, die mehrere Kontaktelemente (Pins) beinhalten, wobei jeweils ein Pin einen Anschluss bildet. Häufig werden M8-Buchsen mit fünf Kontaktpins für den Anschluss von Meldegeräten oder anderen Sensoren auf Feldebene verwendet. Dementsprechend können Ausführungsbeispiele der neuen Steuerungsvorrichtung Feldgeräte sein oder umfassen, die außerhalb eines Schaltschranks in räumlicher Nähe zu dem Roboter 12 angeordnet sind.

Die Steuerungsvorrichtung 1 besitzt in diesem Ausführungsbeispiel zwei redundante Signalverarbeitungskanäle. Beispielhaft sind hier zwei Mikrokontroller 28a, 28b dargestellt, die jeweils mit dem E/A-Teil 24 verbunden sind. Die Mikrokontroller 28a, 28b verarbeiten hier redundant zueinander die Eingangssignale, die das Steuerungsvorrichtung 1 an den Geräteanschlüssen des E/A-Teils 24 aufnimmt, und sie vergleichen ihre Ergebnisse, was mit einem Pfeil 29 dargestellt ist. Anstelle von zwei Mikrokontrollern 28a, 28b können Mikroprozessoren, ASICs, FPGAs und/oder andere Signalverarbeitungsschaltkreise verwendet sein. Bevorzugt besitzen Ausführungsbeispiele der Steuerungsvorrichtung 1 zumindest zwei zueinander redundante Signalverarbeitungskanäle, die jeweils in der Lage sind, logische Signalverknüpfungen vorzunehmen, um in Abhängigkeit davon ein Signal zu erzeugen. Dieses Signal wird dann verwendet, um ein Schaltelement zum Abschalten der technischen Anlage 10 bzw. des Roboters 12 anzusteuern. Eine solche Steuerungsvorrichtung 1 kann dann zum fehlersicheren (FS) Abschalten der Anlage 10, hier des Roboters 12, verwendet werden.

In dem hier dargestellten Fall besitzt die Steuerungsvorrichtung 1 zwei redundante Schaltelemente 30a, 30b. Jedes dieser beiden Schaltelemente ist in der Lage, ein hohes Spannungspotential 32 zu einem Geräteanschluss 38a, 38b der Steuervorrichtung 1 durchzuschalten, um einen Stromfluss zu einem Schütz 40a, 40b zu ermöglichen, oder diesen Stromfluss zu unterbrechen. Damit kann jedes der Schaltelemente 30 einen Aktor, wie einen Schütz oder ein Magnetventil, abschalten.

Die Schütze 40a, 40b besitzen jeweils Arbeitskontakte 42a, 42b. Die Arbeitskontakte 42a, 42b sind hier in Reihe zueinander in einen Stromversorgungspfad von einer Stromversorgung 44 zu dem Roboter 12 angeordnet. Sobald die Steuervorrichtung 1 die Schütze 40a, 40b abschaltet, fallen die Kontakte 42 ab und die Stromversorgung für den Roboter 12 wird abgeschaltet. Den einschlägigen Fachleuten ist klar, dass eine solche "radikale" Abschaltung hier beispielhaft beschrieben ist. Abweichend hiervon können bei einer Sicherheitsanforderung lediglich Teile des Roboters 12 abgeschaltet werden, wie etwa die gefährlichen Antriebe, während andere Teile des Roboters 12 funktionsbereit bleiben. Auch ein verzögertes Abschalten ist denkbar, damit der Roboter 12 ggf. vor dem Abschalten der Antriebe kontrolliert abgebremst werden kann.

Die Steuervorrichtung 1 steuert die Schaltelemente 30a, 30b hier in Abhängigkeit von dem Signal des Schutztürschalters auf der Leitung 19 und in Abhängigkeit von einem weiteren Eingangssignal von einem Not-Aus-Taster 46 an. Auch der Not-Aus-Taster 46 ist über Leitungen mit Geräteanschlüssen der Steuervorrichtung 1 verbunden. Bevorzugt kann jedes der Eingangssignale redundant anliegen bzw. es können jeweils zwei Eingangs- und Ausgangsleitungen oder Anschlüsse vorgesehen sein (in Fig. 1 nicht dargestellt). In dem in Fig. 1 gezeigten Beispiel können also für den Not-Aus-Taster 46 zwei Eingangsleitungen oder Eingänge vorgesehen sein, die jeweils ein Eingangssignal von dem Not-Aus- Taster 46 liefern. Ähnliches gilt für das Signal des Schutztürschalters.

In einigen Ausführungsbeispielen erzeugt die Steuervorrichtung 1 Ausgangssignale, die den einzelnen Meldegeräten zugeführt sind. Beispielhaft ist ein solches Ausgangssignal über eine Leitung 48 zu dem Rahmenteil 18 des Schutztürschalters geführt. Das Rahmenteil 18 schleift das Ausgangssignal des Sicherheitsschaltgerätes 1 von der Leitung 48 auf die Leitung 19, wenn sich das Türteil 16 in der Nähe des Rahmenteils 18 befindet, das heißt wenn die Schutztür 14 geschlossen ist. Daher kann die Steuervorrichtung 1 den Schutztürschalter mit Hilfe des Ausgangssignals auf der Leitung 48 und mit Hilfe des Eingangssignals auf der Leitung 19 überwachen. In vergleichbarer Weise überwacht die Steuervorrichtung 1 hier den Not-Aus-Taster 46.

Abweichend von der Darstellung in Fig. 1 werden in der Praxis häufig zwei redundante Ausgangssignale der Steuervorrichtung 1 verwendet, die jeweils über eine separate Signalleitung zu einem Meldegerät geführt sind und über dieses Meldegerät zurück zur Steuervorrichtung 1 geschleift sind. Beispielhaft für eine solche Realisierung sei auf DE 10 2004 020 995 A1 verwiesen, die hinsichtlich der Details einer solchen redundanten Überwachung eines Meldegerätes durch Bezugnahme aufgenommen ist. Auch der Not-Aus-Taster 46 wird in der Praxis häufig mit redundanten Eingangs- und Ausgangsleitungen überwacht, wie oben erwähnt.

In dem in Fig. 1 dargestellten Ausführungsbeispiel der Steuerungsvorrichtung 1 wird die Steuerungsvorrichtung für Sicherheitsaufgaben verwendet, insbesondere zum fehlersicheren (FS) Abschalten einer Anlage. Die Steuerungsvorrichtung 1 kann jedoch auch für nicht-sicherheitsgerichtete Aufgaben bzw. Standardaufgaben (ST) verwendet werden.

Die Steuerungsvorrichtung 1 kann insbesondere eine programmierbare Steuerungsvorrichtung für eine programmierbare Steuerung der technischen Anlage sein. Alternativ kann die Steuerungsvorrichtung 1 auch eine konfigurierbare Steuerungsvorrichtung sein. Unter konfigurierbar ist hier das Anpassen oder Einstellen eines Hardwarebestandteils der Steuerung zu verstehen, wie beispielsweise einer Verdrahtung. Unter programmierbar ist hier das Anpassen oder Einstellen eines Softwarebestandteils der Steuerung zu verstehen, beispielsweise mittels einer Programmiersprache.

Die Steuervorrichtung 1 kann zumindest einen Bus umfassen, insbesondere einen Kommunikationsbus und/oder Versorgungsspannungsbus. Beispielsweise kann die Steuerungsvorrichtung 1 eine dezentrale Steuerungsvorrichtung sein, deren Komponenten über einen Bus miteinander verbunden sind. Die Steuerungsvorrichtung kann insbesondere ein Kopfmodul umfassen zur Koordination des Datenverkehrs auf dem (Kommunikations-)Bus. Bei einer Steuerungsvorrichtung 1 für Sicherheitsaufgaben kann der (Kommunikations-)Bus beispielsweise ein fehlersicherer Bus wie SafetyBUS p oder PROFINET sein. Bei einer Steuerungsvorrichtung 1 für Standardaufgaben kann der Bus beispielsweise ein Standardfeldbus wie CANOpen oder DeviceNet oder Ähnliches sein.

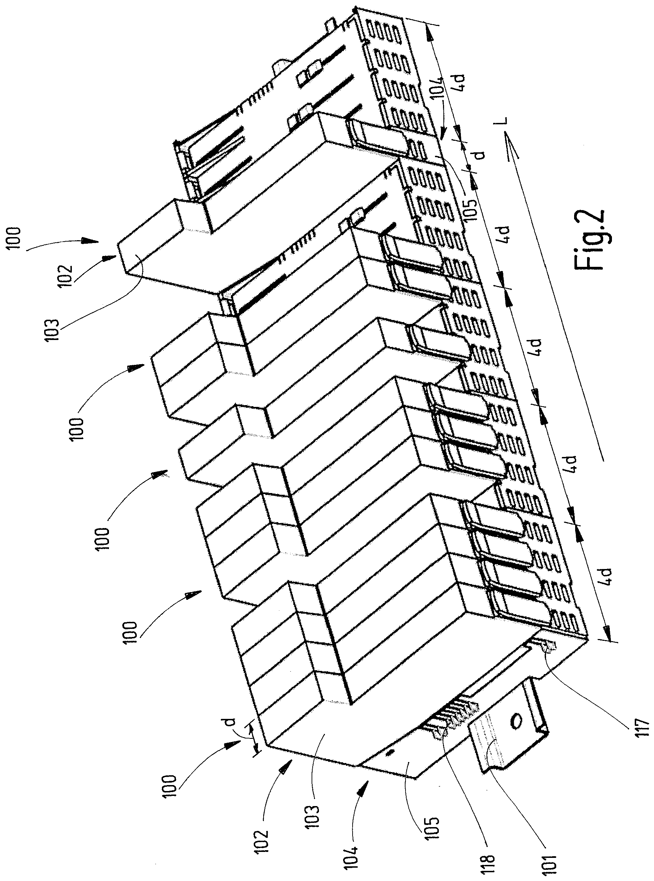

Die Steuerungsvorrichtung 1 ist insbesondere eine modulare Steuerungsvorrichtung mit zumindest einem Modul. Fig. 2 zeigt eine perspektivische Darstellung eines Ausführungsbeispiels der modularen Steuerungsvorrichtung mit mehreren nebeneinander angeordneten Modulen 100 mit ersten Modulteilen 102 und zweiten Modulteilen 104. Dritte Modulteile 106 sind in Fig. 2 nicht dargestellt. Das erste Modulteil 102 umfasst ein Gehäuse 103. Das zweite Modulteil 104 umfasst ein Gehäuse 105. Das zweite Modulteil 104 umfasst zumindest einen Busanschluss 117, 118. Das zweite Modulteil 104 wird daher im Folgenden auch Busmodulteil genannt.

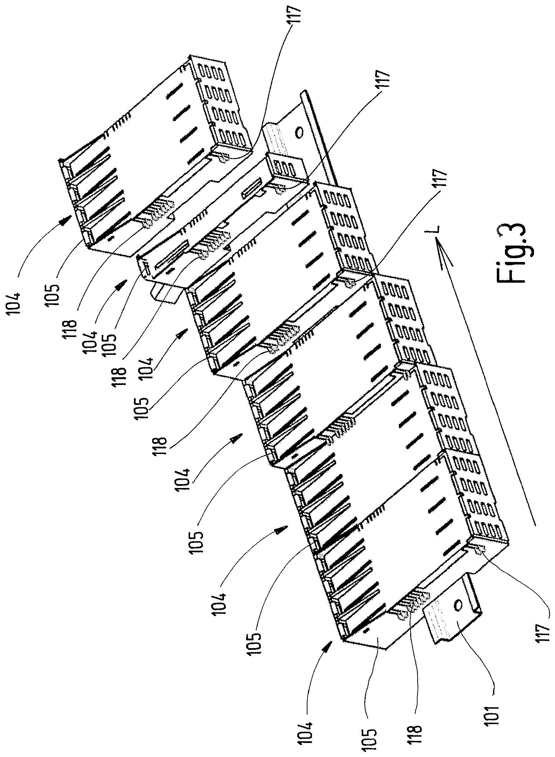

Fig. 3 zeigt eine perspektivische Darstellung des Ausführungsbeispiels der Steuervorrichtung nach Fig. 2 mit nur den zweiten Modulteilen (Busmodulteile) 104. Die zweiten Modulteile (Busmodulteile) 104 bzw. die Module 100 sind in einer Längsrichtung L nebeneinander angeordnet. Die zweiten Modulteile 104 bzw. die Module 100 werden, wie in Fig. 3 gezeigt, auf einer Führungsschiene 101 montiert. Das zweite Modulteil (Busmodulteil) 104 weist einen Busanschluss 117 für einen Versorgungsspannungsbus und einen Busanschluss 118 für einen Kommunikationsbus auf. Das zweite Modulteil (Busmodulteil) 104 umfasst einen ersten elektrischen Busanschluss 117, 118 an einer ersten Seite des Gehäuses 105 zur elektrischen Verbindung mit einem in Längsrichtung L danebenliegenden Nachbarmodulteil (in Fig. 2 und 3 einem rechts danebenliegenden Nachbarmodulteil). Das zweite Modulteil (Busmodulteil) 104 umfasst weiterhin einen zweiten elektrischen Busanschluss 117', 118' (in Fig. 3 nicht zu sehen) an einer zweiten, der ersten Seite gegenüberliegenden Seite des Gehäuses 105 zur elektrischen Verbindung mit einem in Längsrichtung L danebenliegenden anderen Nachbarmodulteil (in Fig. 2 und Fig. 3 einem links danebenliegenden Nachbarmodulteil). Insbesondere kann der zweite elektrische Busanschluss 117', 118' mit dem entsprechenden ersten elektrischen Busanschluss 117, 118 des anderen Nachbarmodulteils verbunden werden. Auf diese Weise wird der Versorgungsspannungsbus und der Kommunikationsbus über die zweiten Modulteile (Busmodulteile) 104 hinweg durchgeschaltet.

Die Steuerungsvorrichtung 1 kann weiterhin ein Kopfmodul (in Fig. 2 und Fig. 3 nicht dargestellt) umfassen, das Schnittstellen und ein Verarbeitungsteil umfasst, insbesondere zur Koordination des Datenverkehrs auf dem (Kommunikations-)Bus wie zuvor beschrieben. Das Kopfmodul kann dann ebenfalls auf der Führungsschiene 101 montiert sein bzw. werden. Das Kopfmodul kann in Längsrichtung L neben den zweiten Modulteilen (Busmodulteile) 104 bzw. Modulen 100, wie oben beschrieben, angeordnet sein. In Fig. 2 und Fig. 3 kann das Kopfmodul beispielsweise links neben dem in Längsrichtung L ersten Modul 100 angeordnet sein und über den ersten Busanschluss 117, 118 mit den Modulen verbunden sein. Jedes Modul 100, bzw. das entsprechende erste Modulteil (Elektronikmodulteil) 102, kann ein E/A(Ein-/Ausgabe)-Modul bzw. Modulteil sein. Das E/A-Modul bzw. Modulteil kann ein fehlersicheres Modul (Fail-safe bzw. FS) oder ein nicht-fehlersicheres Standardmodul (ST) sein. Beispielhaft für eine solche Realisierung sei auf WO 2005/003869 A1 verweisen, die hinsichtlich Details einer solchen modularen Steuerungsvorrichtung durch Bezugnahme aufgenommen ist.

Wie in Fig. 3 ersichtlich wird durch die nebeneinanderliegenden zweiten Modulteile (Busmodulteile) 104 eine sogenannte Backplane bereitgestellt. Auf dieser Backplane können dann erste Modulteile 102 frei wählbar angeordnet werden. Die Backplane bildet hier insbesondere eine im Wesentlichen ebene Fläche. Eine fortlaufende Aneinanderreihung von ersten Modulteilen (Elektronikmodulteilen) 102 auf der Backplane ist nicht zwingend notwendig. Wie in Fig. 2 zu sehen, muss auf einem bestimmten zweiten Modulteil (Busmodulteil) 104, bzw. einem bestimmten Abschnitt einer Grundbreite d eines zweiten Busmodulteils (Busmodulteil) 104, nicht zwingend ein erstes Modulteil (Elektronikmodulteil) 102 angeordnet sein.

Wieder Bezug nehmend auf Fig. 2 kann auf ein jeweils zweites Modulteil 104 (Busmodulteil) zumindest ein erstes Modulteil 102 aufgesteckt werden. Bevorzugt umfasst das erste Modulteil 102 eine elektrische Steuerungsschaltung zum automatisierten Steuern, beispielsweise mit einer oder mehreren Verarbeitungseinheiten, wie in Bezug auf Fig. 1 erklärt. Das erste Modulteil 102 wird im Folgenden auch Elektronikmodulteil genannt. Das erste Modulteil 102 (Elektronikmodulteil) und das zweite Modulteil 104 (Busmodulteil) können mechanisch und elektrisch in eine erste zusammengesetzte Anordnung zusammengesetzt werden, wie in Fig. 2 gezeigt. Durch diesen modularen Aufbau der Steuerungsvorrichtung 1 ist die Reaktion auf Änderungen und Anpassungen ohne größeren Aufwand möglich.

In dem in Fig. 2 und Fig. 3 dargestellten Ausführungsbeispiel wird das zweite Modulteil (Busmodulteil) 104 in mehreren Breitenformen bereitgestellt. Das erste Modulteil (Elektronikmodulteil) 102 hat eine Grundbreite d in Längsrichtung L. Einige der zweiten Modulteile 104 (Busmodulteil) haben jeweils eine Breite in Längsrichtung L, die ein ganzzahliges Vielfaches (n-faches) der Grundbreite d ist, insbesondere hier eine Breite, die ein Vierfaches der Grundbreite d ist (in Fig. 2 und Fig. 3 mit 4d bezeichnet). In diesem Fall ist das ganzzahlige Vielfache also ein gradzahliges Vielfaches, nämlich 4. Die Vierfache Grundbreite hat sich als besonders geeignet erwiesen für das Zusammensetzen einer größeren Backplane. Es kann jedoch auch jedes andere geeignete ganzzahlige Vielfache gewählt werden.

Wie in dem Ausführungsbeispiel der Fig. 2 und Fig. 3 zu sehen, hat ein anderes zweites Modulteil (Busmodulteil) 104 eine Breite, die der Grundbreite d entspricht. Das zweite Modulteil (Busmodulteil) wird also in zwei Breitenformen mit unterschiedlichen Breiten bereitgestellt. In einer ersten Breitenform mit der Grundbreite d und in einer zweiten Breitenform mit einer Breite 4d, die ein Vierfaches der Grundbreite d ist. Die Backplane kann so durch Anordnen nebeneinanderliegender zweiter Modulteile (Busmodulteile) der ersten und/oder zweiten Breitenform frei wählbar zusammengestellt werden. Durch Vorsehen von zweiten Modulteilen (Busmodulteile) 104 einer Breite, die ein ganzzahliges Vielfaches der Grundbreite d ist, werden weniger zweite Modulteile 104 benötigt, verglichen mit der Verwendung von ausschließlich zweiten Modulteilen 104 der Grundbreite d.

In dem in Fig. 2 dargestellten Ausführungsbeispiel haben alle ersten Modulteilen (Elektronikmodulteile) 102 die Grundbreite d in Längsrichtung L. Es können jedoch auch andere erste Modulteile 102 bereitgestellt werden, die eine Breite in Längsrichtung L haben, die ein ganzzahliges Vielfaches der Grundbreite d (m-faches) ist, insbesondere ein gradzahliges Vielfaches (z.B. 2-faches). Beispielsweise können andere erste Modulteile eine Breite in Längsrichtung aufweisen, die ein Zweifaches der Grundbreite d ist. Das erste Modulteil (Elektronikmodulteil) wird so in zwei Breitenformen mit zwei unterschiedlichen Breiten bereitgestellt. In einer ersten Breitenform mit der Grundbreite d und in einer zweiten Breitenform mit einer Breite, die ein ganzzahliges Vielfaches (m-faches) der Grundbreite d ist. Das erste Modulteil in der zweiten Breitenform kann dann über eine Trennstelle zwischen zwei nebeneinanderliegenden zweiten Modulteilen (Busmodulteilen) 104 hinweg angeordnet werden.

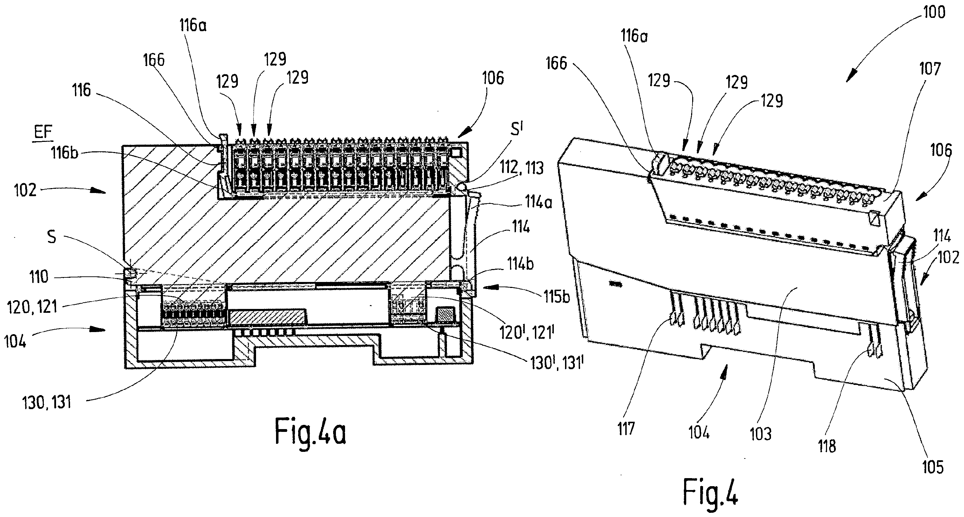

Fig. 4 zeigt eine perspektivische Darstellung eines ersten Ausführungsbeispiels eines Moduls 100, das ein erstes Modulteil 102, ein zweites Modulteil 104, und ein drittes Modulteil 106 umfasst. Fig. 4a zeigt eine entsprechende Querschnittsansicht des in Fig. 4 gezeigten Moduls 100. Das erste bzw. zweite Modulteil 102, 104 in diesem Ausführungsbeispiel kann insbesondere ein erstes bzw. zweites Modulteil sein, wie in Bezug auf Fig. 2 und Fig. 3 erläutert. Das dritte Modulteil 106 umfasst ein Gehäuse 107. Das dritte Modulteil 106 umfasst weiterhin zumindest einen externen Anschluss 129 zum Anlegen eines Signals oder einer Spannung von außen. Die Anschlüsse 129 können insbesondere die in Bezug auf Fig. 1 beschriebenen Anschlüsse 29 sein oder umfassen. In Fig. 4 und Fig. 4a sind eine Mehrzahl von externen Anschlüssen 129 dargestellt, die nebeneinanderliegend am Gehäuse 107 des dritten Modulteils angeordnet sind. Das dritte Modulteil 106 wird daher im Folgenden auch Anschlussmodulteil genannt. In dem dargestellten Ausführungsbeispiel umfasst das dritte Modulteil 106 sechzehn externe Anschlüsse 129, die in einer einzigen Reihe angeordnet sind (16-polig und einreihig). Es sollte jedoch verstanden werden, dass jede andere geeignete Anzahl und Anordnung von externen Anschlüssen vorgesehen sein kann. Ein externer Anschluss kann ein Ausgang zum Übermitteln eines Ausgangssignals (beispielsweise an einen Aktor) oder ein Eingang zum Aufnehmen eines Eingangssignals (beispielsweise von einem Sensor) sein.

Wie bereits in Bezug auf Fig. 2 erläutert, können das erste Modulteil 102 und das zweite Modulteil 104 mechanisch und elektrisch in eine erste zusammengesetzte Anordnung zusammengesetzt werden. Auch das erste Modulteil 102 und das dritte Modulteil 106 können mechanisch und elektrisch in einer zweiten zusammengesetzten Anordnung zusammengesetzt werden. Fig. 4 und Fig. 4a zeigen die Modulteile in der ersten und zweiten zusammengesetzten Anordnung.

Das mechanische Zusammensetzen der Modulteile wird nun im Folgenden detaillierter beschrieben mit Bezug auf Fig. 4a. Wie in Fig. 4a ersichtlich, weist das dritte Modulteil (Anschlussmodulteil) 106 ein Schwenkhalterungselement 112 auf, an dem das erste Modulteil (Elektronikmodulteil) 104 lösbar gehalten werden kann bzw. wird. Das Schwenkhalterungselement 112 definiert so einen Schwenkpunkt S' mit einer Schwenkachse A'. Auf diese Weise können das erste Modulteil 102 und das dritte Modulteil 106 durch eine Schwenkbewegung entlang einer definierten Bewegungsbahn in die zweite zusammengesetzte Anordnung mechanisch zusammengesetzt werden. Wie in Fig. 4a ersichtlich, umfasst auch das erste Modulteil (Elektronikmodulteil) 102 ein Schwenkhalterungselement 110, an dem das zweite Modulteil 104 (Busmodulteil) lösbar gehalten werden kann bzw. wird. Das Schwenkhalterungselement 110 definiert so einen Schwenkpunkt S mit einer Schwenkachse A. Auf diese Weise können das erste Modulteil 102 und das zweite Modulteil 104 durch eine Schwenkbewegung entlang einer definierten Bewegungsbahn in die zweite zusammengesetzte Anordnung zusammengesetzt werden. In dem in Fig. 4a dargestellten Ausführungsbeispiel umfasst das Schwenkhalterungselement 110, 112 jeweils einen Vorsprung (z.B. gekrümmter Vorsprung, Haken oder ähnliches), der in eine Aussparung des entsprechend anderen Modulteils eingreift. Es wird so eine schwenkbare Verbindung bereitgestellt. Die Modulteile können so durch eine einfache Schwenkbewegung um einen fest definierten Schwenkpunkt sicher und zuverlässig zusammengesetzt werden. In dem dargestellten Ausführungsbeispiel sind das Schwenkhaltungselement 110 des ersten Modulteils 102 und das Schwenkhalterungselement 112 des dritten Modulteils an sich einander gegenüberliegenden Seiten des Moduls 100 angeordnet. Somit ist in das dritte Modulteil 106 in eine erste Richtung (nach rechts in Fig. 4a) abschwenkbar und das erste Modulteils 102 ist in eine zweite, der ersten entgegengesetzte Richtung (nach links in Fig. 4a) abschwenkbar.

Das elektrische Zusammensetzen der Modulteile wird nun im Folgenden detaillierter beschrieben mit Bezug auf Fig. 4a. Das erste Modulteil (Elektronikmodulteil) 102 umfasst zumindest einen elektrischen Kontakt 120 und das zweite Modulteil (Busmodulteil) 104 umfasst zumindest einen ersten elektrischen Gegenkontakt 130, der in der ersten zusammengesetzten Anordnung den ersten elektrischen Kontakt 120 kontaktiert zur elektrischen Verbindung zwischen dem ersten Modulteil (Elektronikmodulteil) 102 und dem zweiten Modulteil (Busmodulteil) 104. Der erste elektrische Kontakt 120 des ersten Modulteils 102 ist eine Leiterbahn auf einer nicht-leitenden Platte, so dass eine Leiterplatte 121 gebildet wird. Der erste Gegenkontakt 130 des zweiten Modulteils 104 ist ein Kontaktelement (Pin), das in einem Stecker oder Buchse 131 angeordnet ist. In den Stecker oder die Buchse 131 kann die Leiterplatte 121 eingeführt werden. Es wird somit eine Steckverbindung gebildet. Insbesondere sind eine Mehrzahl von elektrischen Kontakten 120 und eine Mehrzahl von entsprechenden Gegenkontakten 130 vorgesehen. Die Mehrzahl von Kontakten 120 sind nebeneinanderliegend auf der Leiterplatte 121 angeordnet. Die Mehrzahl von entsprechenden Gegenkontakten 130 sind entsprechend nebeneinanderliegend in dem Stecker oder Buchse 131 angeordnet.

Wie in Fig. 4 und Fig. 4a zu sehen, bilden die Kontakte 120 und die entsprechenden Gegenkontakte 130 jeweils eine erste Gruppe. In diesem Ausführungsbeispiel dient die erste Gruppe dazu, die Spannung oder das Signal des Kommunikationsbuses, der mittels der Busanschlüsse 117 durchgeschaltet wird, von dem zweiten Modulteil (Busmodulteil) 104 auf das erste Modulteil (Elektronikmodulteil) 102 zu übertragen. Es ist weiterhin eine zweite Gruppe von Kontakten 120' auf einer entsprechenden Leiterplatte 121' vorgesehen, sowie entsprechende Gegenkontakte 130' in einem Stecker oder Buchse 131', wie bereits in Bezug auf die Kontakte 120 und Gegenkontakte 130 beschrieben. In diesem Ausführungsbeispiel dient die zweite Gruppe der Kontakte 120' bzw. Gegenkontakte 130' dazu, die Spannung des Versorgungsspannungsbuses, der mittels der Busanschlüsse 118 durchgeschaltet wird, von dem zweiten Modulteil (Busmodulteil) 104 auf das erste Modulteil (Elektronikmodulteil) 102 zu übertragen.

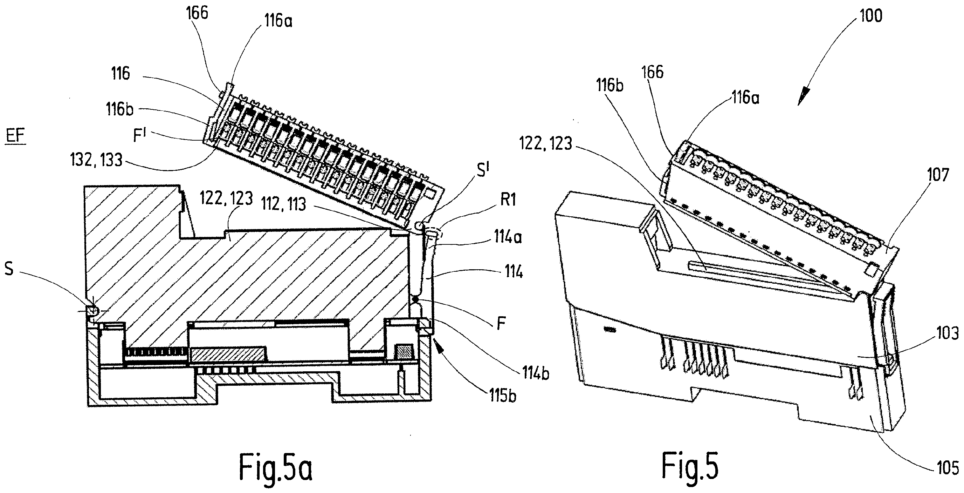

Fig. 5 zeigt eine perspektivische Darstellung des ersten Ausführungsbeispiels des Moduls 100 der Fig. 4 in einem Zustand, in dem das dritte Modulteil (Anschlussmodulteil) 106 gelöst wird. Fig. 5a zeigt eine entsprechende Querschnittsansicht des in Fig. 5 gezeigten Moduls 100. Wie in Fig. 5 und Fig. 5a zu sehen umfasst auch das dritte Modulteil (Anschlussmodulteil) 106 zumindest einen ersten elektrischen Kontakt 132 und das erste Modulteil (Elektronikmodulteil) 102 umfasst zumindest einen entsprechenden ersten elektrischen Gegenkontakt 122, der in der zweiten zusammengesetzten Anordnung den ersten elektrischen Kontakt 132 des dritten Modulteils (Busmodulteils) 106 kontaktiert zur elektrischen Verbindung zwischen dem ersten Modulteil (Elektronikmodulteil) 102 und dem dritten Modulteil (Anschlussmodulteil) 106. Der erste elektrische Gegenkontakt 122 des ersten Modulteils 102 ist eine Leiterbahn auf einer nicht-leitenden Platte, so dass eine Leiterplatte 123 gebildet wird. Der erste elektrische Kontakt 132 des dritten Modulteils 106 ist ein Kontaktelement (Pin), das in einem Stecker oder Buchse 133 angeordnet ist. In den Stecker oder die Buchse 133 kann die Leiterplatte 123 eingeführt werden. Es wird somit eine Steckverbindung gebildet. Insbesondere sind eine Mehrzahl von ersten elektrischen Kontakten 132 des dritten Modulteils 106 und eine Mehrzahl von entsprechenden ersten elektrischen Gegenkontakten 122 des ersten Modulteils 102 vorgesehen. Die Mehrzahl von ersten elektrischen Kontakten 132 des dritten Modulteils 106 sind nebeneinanderliegend in dem Stecker oder Buchse 133 angeordnet. Die Mehrzahl von entsprechenden ersten elektrischen Gegenkontakten 122 des ersten Modulteils 102 sind entsprechend nebeneinanderliegend auf der Leiterplatte 123 angeordnet.

Um das erste und zweite Modulteil 102, 104 in der ersten zusammengesetzten Anordnung aneinander zu sichern, umfasst das erste Modulteil 102 (Elektronikmodulteil) ein Sicherungselement 114 mit einem Sicherungseingriffsabschnitt 114b. Das Sicherungselement 114 bzw. der Sicherungseingriffsabschnitt 114b ist in eine erste und eine zweite Position beweglich. In der ersten Position, wie in Fig. 4 und Fig. 4a dargestellt, ist der Sicherungseingriffsabschnitt 114b mit dem zweiten Modulteil 104 (Busmodulteil) in der ersten zusammengesetzten Anordnung im sichernden Eingriff, so dass das erste Modulteil (Elektronikmodulteil) 102 und das zweite Modulteil (Busmodulteil) 104 aneinander gesichert sind. Der Sicherungseingriffsabschnitt 114b der Fig. 4a ist ein Vorsprung oder Balken, der in der ersten Position in sicherndem Eingriff mit einer Aussparung 115b des zweiten Modulteils 104 ist. Es sollte verstanden werden, dass dieses mechanische Eingreifen auf jede geeignete Art erreicht bzw. beschrieben werden kann. Beispielsweise kann auch ein Vorsprung oder Balken des zweiten Modulteils 104 in eine Aussparung des ersten Modulteils 102 bzw. des Sicherungselementes 114 eingreifen.

In der zweiten Position (in Fig. 4 und Fig. 5 nicht dargestellt) des Sicherungselementes 114, ist der Sicherungseingriffsabschnitt 114b in der ersten zusammengesetzten Anordnung derart angeordnet, dass das erste Modulteil (Elektronikmodulteil) 102 und das zweite Modulteil (Busmodulteil) 104 voneinander lösbar sind. In der zweiten Position des Sicherungselementes 114 sind das erste Modulteil (Elektronikmodulteil) 102 und das zweite Modulteil (Busmodulteil) 104 daher nicht aneinander gesichert. Das Sicherungselement 114 umfasst weiterhin einen Sicherungsbetätigungsabschnitt 114a, mittels dessen das Sicherungselement 114 in der ersten zusammengesetzten Anordnung zwischen der ersten und zweiten Position beweglich ist bei Ausüben einer Kraft auf den Sicherungsbetätigungsabschnitt 114a.

Wie in Fig. 4, 4a, 5 und 5a zu sehen, umfasst auch das dritte Modulteil 106 (Anschlussmodulteil) ein Sicherungselement 116 mit einem Sicherungseingriffsabschnitt 116b, um das erste und dritte Modulteil 102, 106 in der zweiten zusammengesetzten Anordnung aneinander zu sichern. Das Sicherungselement 116 bzw. der Sicherungseingriffsabschnitt 116b ist in eine erste und eine zweite Position beweglich. In der ersten Position, wie in Fig. 4a dargestellt, ist der Sicherungseingriffsabschnitt 116b mit dem ersten Modulteil 102 (Elektronikmodulteil) in der zweiten zusammengesetzten Anordnung im sichernden Eingriff, so dass das erste Modulteil (Elektronikmodulteil) 102 und das dritte Modulteil (Anschlussmodulteil) 106 aneinander gesichert sind. Der Sicherungseingriffsabschnitt 116b der Fig. 4a ist ein Vorsprung oder Balken, der in der ersten Position in sicherndem Eingriff mit einer Aussparung des ersten Modulteils 102 ist. Es sollte verstanden werden, dass dieses mechanische Eingreifen auf jede geeignete Art erreicht bzw. beschrieben werden kann. Beispielsweise kann auch ein Vorsprung oder Balken des ersten Modulteils 102 in eine Aussparung des dritten Modulteils 106 bzw. des Sicherungselementes 116 eingreifen.

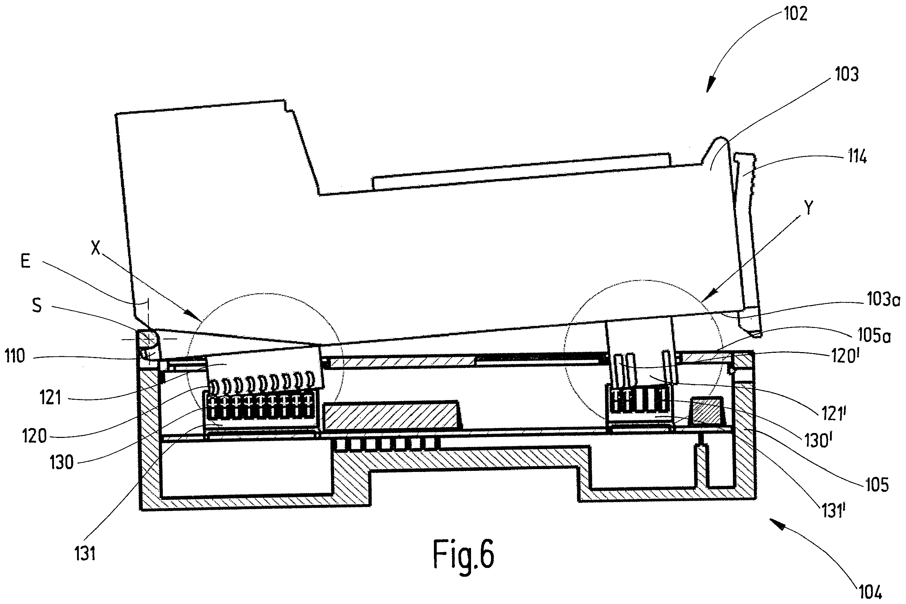

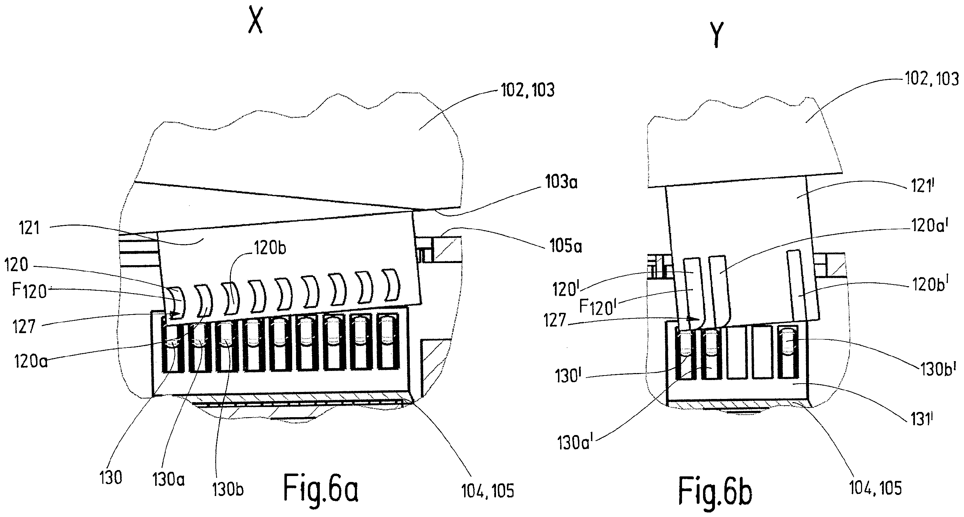

Fig. 6 zeigt eine Querschnittsansicht des ersten Ausführungsbeispiels des Moduls der Fig. 4 bis 5 in einem Zustand, in dem das erste Modulteil gelöst wird. Das mechanische Zusammensetzen bzw. Lösen des ersten Modulteils (Elektronikmodulteil) 102 und des zweiten Modulteils (Busmodulteil) 104 wird im Folgenden detaillierter beschrieben. Das Gehäuse 103 des ersten Modulteils (Elektronikmodulteil) 102 umfasst hier eine Grenzfläche 103a und das Gehäuse 105 des zweiten Modulteils (Busmodulteil) 104 umfasst eine Grenzfläche 105a (in Fig. 6 sichtbar), die sich in der ersten zusammengesetzten Anordnung bzw. Zustand (wie beispielsweise in Fig. 4 bis 5 zu sehen), derart gegenüberliegen, dass eine Grenzebene G definiert ist. In den Fig. 4a und 5a verläuft die Grenzebene G horizontal in die Zeichenebene hinein. Durch die Schwenkachse A, die durch das Schwenkhaltungselement 110 des ersten Modulteils 102 definiert ist (wie zuvor beschrieben), wird eine Schwenkachsenebene E definiert (wie in Fig. 6 zu sehen). In Fig. 6 verläuft die Schwenkachsenebene E vertikal in die Zeichenebene hinein. Die Grenzebene G und die Schwenkachsenebene E sind orthogonal zueinander. Die Grenzflächen 105a der zweiten Modulteile (Busmodulteile) 104 bilden die Backplane. Die Leiterplatten 121, 121' des ersten Modulteils 102 können in entsprechende Aussparungen (mit Gegenkontakten 130, 130' bzw. Steckern oder Buchsen 131, 131') in dem Gehäuse 105 bzw. der Grenzfläche 105a des zweiten Modulteils eingeführt werden. Das erste Modulteil (Elektronikmodulteil) 102 und zweite Modulteil (Busmodulteil) 104 liegen daher in der ersten zusammengesetzten Anordnung bzw. Zustand plan aufeinander auf, in der Grenzebene G.

Fig. 6a zeigt einen ersten vergrößerten Bereich X der Querschnittsansicht der Fig. 6 und Fig. 6b zeigt einen zweiten vergrößerten Bereich Y der Querschnittsansicht der Fig. 6. Fig. 6a zeigt die Kontakte 120, die die erste Gruppe bilden, wie zuvor beschrieben, und die entsprechenden Gegenkontakte 130. Fig. 6b zeigt die Kontakte 120', die die zweite Gruppe bilden, wie zuvor beschrieben, und die entsprechenden Gegenkontakte 130'. In der ersten zusammengesetzten Anordnung kontaktiert jeder Kontakt 120, 120a, 120b bzw. 120', 120a', 120b' seinen entsprechenden Gegenkontakt 130, 130a, 130b, bzw. 130', 130a', 130b' zur elektrischen Verbindung zwischen dem ersten Modulteil 102 und dem zweiten Modulteil 104. Die Kontakte 120, 120a, 120b bzw. 120', 120a', 120b' und die Gegenkontakte 130, 130a, 130b bzw. 130', 130a', 130b' sind in einer Kontaktebene K, die senkrecht zur Schwenkachse A verläuft, nebeneinander angeordnet. In Fig. 6, 6a und 6b verläuft die Kontaktebene K in bzw. parallel zu der Zeichen ebene.

In Fig. 6a und Fig. 6b sind jeweils beispielhaft ein erster elektrischer Kontakt 120 bzw. 120', ein in radial auswärtiger Richtung neben dem ersten Kontakt liegender zweiter Kontakt 120a bzw. 120a' und ein in radial auswärtiger Richtung neben dem zweiten Kontakt liegender dritter Kontakt 120b bzw. 120b' mit Bezugsziffern versehen. Zudem sind die entsprechenden Gegenkontakte 130, 130a, 130b bzw. 130', 130a', 130b' mit Bezugsziffern versehen. Wie in Fig. 6a zu sehen, umfasst die erste Gruppe von Kontakten noch weitere Kontakte. Es sollte verstanden werden, dass jede beliebige Anzahl von Kontakten vorgesehen sein kann.

Die Kontakte 120, 120a, 120b bzw. 120', 120a', 120b' sind jeweils auf einer entsprechenden Leiterplatte 121 bzw. 121' vorgesehen. Die Kontakte sind jeweils eine Leiterbahn auf einer nicht leitenden Platte, so dass die Leiterplatte 121 bzw. 121' gebildet wird. Die Leiterbahn kann insbesondere durch Aufdrucken und/oder Ätzen bereitgestellt werden. Die Gegenkontakte 130, 130a, 130b bzw. 130', 130a', 130b' sind jeweils ein Kontaktelement (Pin), das in dem Stecker oder Buchse 131 angeordnet ist. Die Gegenkontakte 130, 130a, 130b bzw. 130', 130a', 130b' sind Kontaktelemente (Pins), die nebeneinanderliegend in dem Stecker oder Buchse 131 angeordnet sind. In den Stecker oder die Buchse 131, 131' kann die Leiterplatte 121, 121' eingeführt werden. In der ersten zusammengesetzten Anordnung ist die Leiterplatte 121, 121' in den Stecker oder die Buchse 131, 131' eingeführt. So kann jeder Kontakt 120, 120a, 120b bzw. 120', 120a', 120b' seinen entsprechenden Gegenkontakt 130, 130a, 130b bzw. 130', 130a', 130b' kontaktieren zur elektrischen Verbindung zwischen den Modulteilen 102, 104.

Der erste elektrische Kontakt 120 weist eine durch eine erste Außenkontur begrenzte freiliegende Kontaktfläche F₁₂₀ mit einem in der Bewegungsbahn der Schwenkbewegung vorlaufendem Ende 127 auf. Insbesondere weist jeder der Anzahl von Kontakten 120, 120a, 120b bzw. 120', 120a', 120b' eine durch eine Außenkontur begrenzte freiliegende Kontaktfläche F₁₂₀ mit einem in der Bewegungsbahn vorlaufenden Ende auf, wie in Fig. 6, 6a und Fig. 6b zu sehen. Unter freiliegender Kontaktfläche ist insbesondere die nach außen hin freiliegende bzw. kontaktierbare, elektrisch leitfähige Fläche zu verstehen. Außerhalb der freiliegenden Kontaktfläche F₁₂₀ kann sich ein elektrisch isolierendes Material befinden. Die Leiterbahn eines Kontakts verläuft von der freiliegenden Fläche in das Gehäuse des ersten Modulteils 102 hinein. Wie in Fig. 6, 6a und 6b zu sehen, befindet sich über einem Bereich einer jeweiligen Leiterbahn, der nicht die freiliegende Kontaktfläche F₁₂₀ bildet, ein elektrisch isolierendes Material. Der Verlauf der Leiterbahn von der freiliegenden Kontaktfläche F₁₂₀ in das Gehäuse 103 des ersten Modulteils 102 hinein ist daher in Fig. 6, 6a und 6b nicht zu sehen.

Die Außenkontur umfasst (in der zusammengesetzten Anordnung bzw. Zustand) zumindest am vorlaufenden Ende 127 einen zur Schwenkachsenebene E hin geneigten Abschnitt. In Fig. 6a umfasst jeder der Kontakte 120, 120a, 120b einen zur Schwenkachsenebene E hin geneigten Abschnitt. In Fig. 6b umfasst nur ein Teil der Kontakte, hier Kontakte 120' und 120a' einen zur Schwenkachsenebene hin geneigten Abschnitt. In Fig. 6b hat der dritte Kontakt 120b' eine Kontaktfläche mit einer konventionellen rechteckigen Außenkontur.

Der geneigte Abschnitt in Fig. 6, 6a und 6b umfasst eine Krümmung. Der geneigte Abschnitt befindet sich zumindest in dem Bereich des vorlaufenden Endes 127 der ersten Außenkontur, der den größten radialen Abstand zum Schwenkpunkt S aufweist (untere rechte Ecke der Außenkontur in den Figuren). Es wird also insbesondere der kritische Bereich der Außenkontur angepasst bzw. geneigt. Der kritische Bereich ist der Bereich des vorlaufenden Endes 127 der Außenkontur, der (in Bezug auf das gesamte vorlaufende Ende) den größten radialen Abstand zum Schwenkpunkt S aufweist. Die Gegenkontakte 130, 130a, 130b bzw. 130', 130a', 130b' bzw. die Außenkonturen ihrer freiliegenden Kontaktflächen hingegen weisen keinen geneigten Abschnitt auf. Die Gegenkontakte 130, 130a, 130b bzw. 130', 130a', 130b' verlaufen in ihrer Längsrichtung parallel zur Schwenkachsenebene E. Bei vierseitiger oder rechteckiger Außenkontur verläuft die Außenkontur der freiliegenden Kontaktfläche eines Gegenkontakts ausschließlich senkrecht und/oder parallel zur Schwenkachsenebene E. Sie weist keinen geneigten Abschnitt auf. Somit kann weiterhin ein konventioneller Stecker oder Buchse 131 verwendet werden.

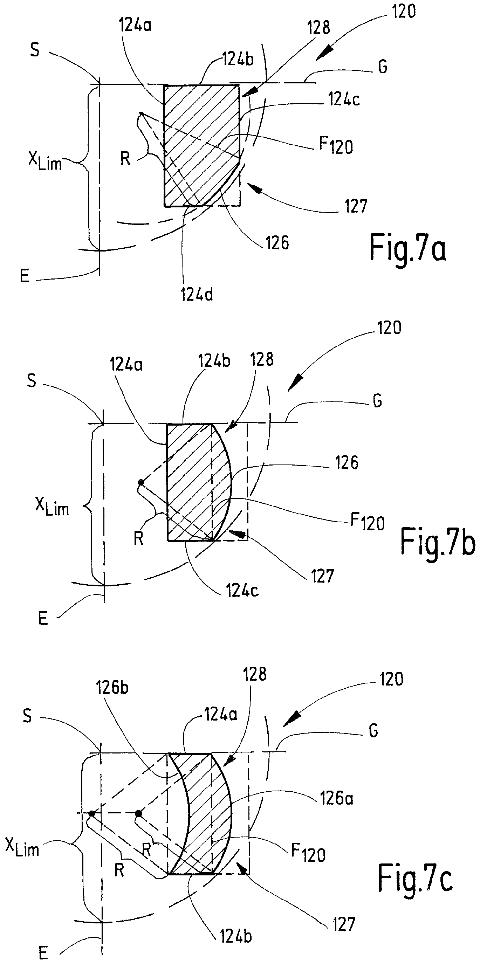

Fig. 7a, 7b und 7c zeigen jeweils eine Kontaktfläche F₁₂₀ (schraffiert dargestellt), deren Außenkontur einen geneigten Abschnitt mit zumindest einer Krümmung umfasst. Die Außenkontur weist ein in der Bewegungsbahn vorlaufendes Ende 127 und ein in der Bewegungsbahn nachlaufendes Ende 128 auf. In Fig. 7a-c befindet sich der geneigte Abschnitt mit der Krümmung in dem Bereich bzw. der Ecke des vorlaufenden Endes 127, der den größten radialen Abstand x zum Schwenkpunkt S aufweist. Jeder Punkt der Außenkontur weist während der Schwenkbewegung einen bestimmten radialen Abstand x zum fest definierten Schwenkpunkt S auf. Wie in Fig. 7a-c zu sehen weist jeder Punkt der ersten Außenkontur einen radialen Abstand x auf, der kleiner ist als ein radialer Abstand xₗᵢₘ (Grenzabstand oder kritischer Abstand).

In Fig. 7a ist die Außenkontur eine fünfseitige Außenkontur mit vier geraden Seiten 124a, 124b, 124c, 124d und einer gekrümmten Seite 126 mit der Krümmung (mit Radius R). In Fig. 7a ist der geneigte Abschnitt mit der Krümmung bzw. die gekrümmte Seite 126 in einer Ecke einer ansonsten konventionell rechteckigen (gestrichelt angedeutet) Außenkontur angeordnet. Ausgehend von einer konventionell rechteckigen Außenkontur ist daher hier eine Ecke abgeschrägt. Die in Fig. 7a gezeigte Kontaktfläche F₁₂₀ entspricht im Wesentlichen der Kontaktfläche des ersten oder zweiten Kontakts 120', 120a' der Fig. 6b.

In Fig. 7b ist die Außenkontur eine vierseitige Außenkontur mit drei geraden Seiten 124a, 124b, 124c und einer gekrümmten Seite 126 mit der Krümmung (mit Radius R). In Fig. 7b ist der geneigte Abschnitt mit der Krümmung bzw. die gekrümmte Seite 126 an einer Seite einer ansonsten konventionell rechteckigen (gestrichelt angedeutet) Außenkontur angeordnet.

In Fig. 7c ist die Außenkontur eine vierseitige Außenkontur mit zwei geraden Seiten 124a, 124b und zwei gekrümmten Seiten 126a, 126b, die jeweils die Krümmung umfassen (mit Radius R). Die beiden gekrümmten Seiten 126a, 126b sind zwei parallel zueinander verlaufende gekrümmte Seiten. Auch die beiden geraden Seiten 124a, 124b sind zwei parallel zueinander verlaufende gerade Seiten. Die Kontaktfläche F₁₂₀ der Fig. 7c entspricht im Wesentlichen den Kontaktfläche eines der in Fig. 6a gezeigten Kontakte 120, 120a, 120b.

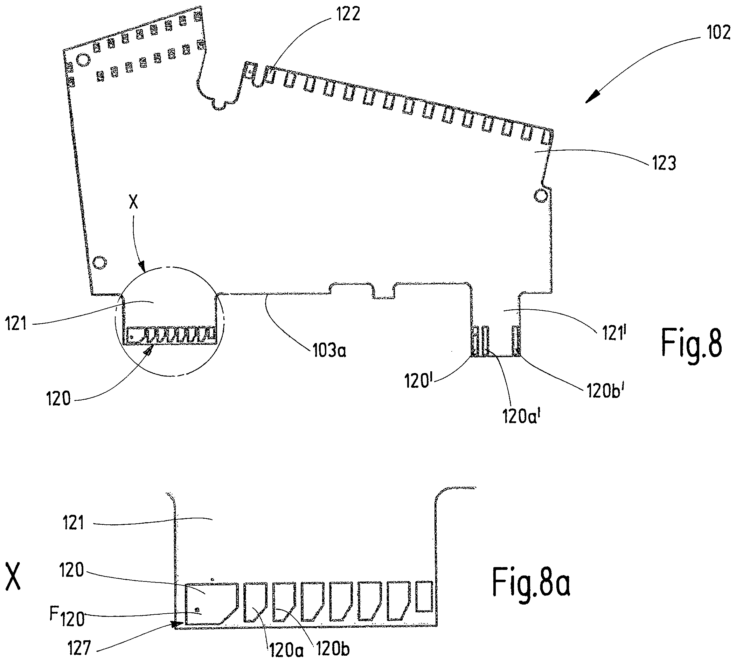

Fig. 8 zeigt eine Querschnittsansicht eines ersten Modulteils 102 einer Variante des ersten Ausführungsbeispiels des Moduls. Fig. 8a zeigt einen vergrößerten Bereich X der Querschnittsansicht der Fig. 8. Die zu dem ersten Ausführungsbeispiel gemachten Ausführungen und Erklärungen treffen ebenfalls auf diese Variante des Ausführungsbeispiels zu. Jedoch umfasst der geneigte Abschnitt in dieser Variante eine Gerade, im Gegensatz zu dem in Fig. 6, 6a und 6b gezeigten geneigten Abschnitt mit Krümmung.

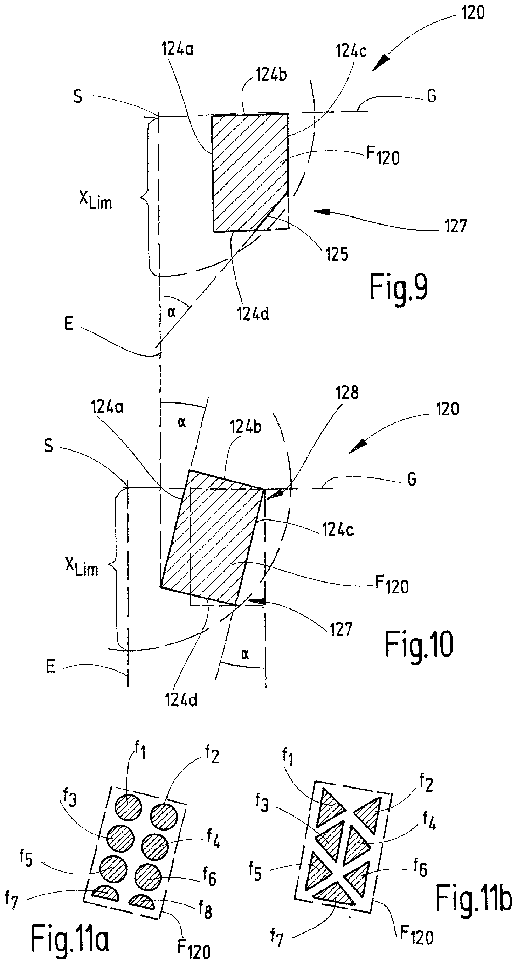

Fig. 9 und Fig. 10 zeigen jeweils eine Kontaktfläche F₁₂₀ (schraffiert dargestellt), deren Außenkontur einen geneigten Abschnitt mit zumindest einer Geraden umfasst. In Fig. 9 ist die Außenkontur eine fünfseitige Außenkontur mit vier geraden Seiten 124a, 124b, 12c, 124d und einer geraden geneigten Seite 125. In Fig. 9 umfasst der geneigte Abschnitt daher genau eine Gerade. Die in Fig. 9 gezeigte Kontaktfläche entspricht im Wesentlichen der in Fig. 8 und 8a gezeigten Kontaktfläche F₁₂₀. In Fig. 9 ist der geneigte Abschnitt mit der Geraden bzw. der geraden geneigten Seite 125 in einer Ecke einer ansonsten konventionell rechteckigen (gestrichelt angedeutet) Außenkontur angeordnet. Ausgehend von einer konventionell rechteckigen Außenkontur ist daher hier eine Ecke abgeschrägt. Die geneigte Seite weist einen bestimmten Winkel α in Bezug auf die Schwenkachsenebene E auf. Der Winkel α ist größer als 0° und kleiner als 90°, insbesondere zwischen 30° und 60°, insbesondere ungefähr 45°.

In Fig. 10 ist der geneigte Abschnitt eine vierseitige Außenkontur mit vier geraden Seiten 124a, 124b, 124c, 124d. Die Außenkontur ist eine konventionelle rechteckige Außenkontur, die jedoch schräg angeordnet ist. Die Seiten 124a und 124c umfassen jeweils den geneigten Abschnitt und bilden jeweils eine gerade geneigte Seite. Die beiden geraden geneigten Seiten 124a, 124c verlaufen parallel zueinander. Die geraden geneigten Seiten 124a, 124c weisen jeweils einen bestimmten Winkel α in Bezug auf die Schwenkachsenebene E auf.

In Bezug auf Fig. 4 bis 10 wurden bestimmte Ausführungsbeispiele der Außenkontur der Kontaktfläche beschrieben. Es sollte jedoch verstanden werden, dass jede andere geeignete Außenkontur der Kontaktfläche verwendet werden kann, solange diese einen wie oben beschriebenen zur Schwenkachsenebene hin geneigten Abschnitt umfasst.

Fig. IIa und Fig. IIb zeigen jeweils eine Kontaktfläche F₁₂₀ mit einer Anzahl von voneinander isolierten Kontaktflächen f. In Fig. IIa sind die voneinander isolierten Kontaktflächen f1 bis f8 jeweils runde bzw. halbrunde Kontaktflächen. In Fig. 11b sind die voneinander isolierten Kontaktflächen f1-f7 jeweils dreieckige Kontaktflächen. Die gewünschte Außenkontur kann so durch eine Anzahl kleinerer Kontaktflächen bereitgestellt werden. Die Außenkontur ist somit sehr variabel anpassbar. Es sollte verstanden werden, dass jede andere Außenkontur der voneinander isolierten Kontaktflächen f verwendet werden kann.

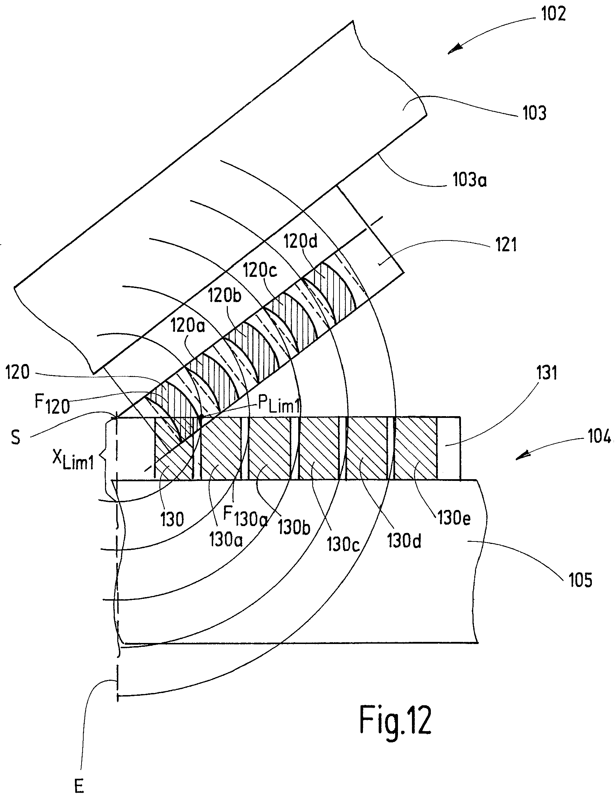

Fig. 12 zeigt eine erste Querschnittsansicht eines Ausschnitts eines ersten Modulteils 102 und eines zweiten Modulteils 104 nach einem Ausführungsbeispiel, in einem Zustand, in dem das erste Modulteil 102 durch Schwenkbewegung aufgesetzt wird. Die zu dem ersten Ausführungsbeispiel gemachten Ausführungen und Erklärungen treffen ebenfalls auf dieses Ausführungsbeispiel zu. Die in Fig. 12 gezeigten Kontakte 120, 120a, 120b, 120c, 120d umfassen jeweils eine Kontaktfläche mit einer Außenkontur mit zwei parallel zueinander verlaufenden gekrümmten Seiten, wie bereits in Bezug auf Fig. 6a beschrieben. Das erste Modulteil 102 umfasst den ersten elektrischen Kontakt 120 und das zweite Modulteil 104 umfasst den entsprechenden elektrischen Gegenkontakt 130. Das zweite Modulteil 104 umfasst weiterhin einen in auswärtiger radialer Richtung neben dem ersten Gegenkontakt 130 liegenden zweiten elektrischen Gegenkontakt 130a. Der zweite elektrische Gegenkontakt 130a weist eine durch eine zweite Außenkontur begrenzte freiliegende Kontaktfläche F₁₃₀ₐ auf. Jeder Punkt der ersten Außenkontur des ersten Kontakts 120 weist während der Schwenkbewegung einen bestimmten radialen Abstand x zum Schwenkpunkt S auf. Jeder Punkt der zweiten Außenkontur des zweiten Gegenkontakts 130a weist während der Schwenkbewegung einen bestimmten radialen Abstand x zum Schwenkpunkt S auf. Jeder Punkt der ersten Außenkontur des ersten Kontakts 120 weist einen radialen Abstand x auf, der kleiner ist als ein radialer Abstand xₗᵢₘ₁ (Grenzabstand oder kritischer Abstand) eines Punktes Pₗᵢₘ₁ der zweiten Außenkontur, der von den Punkten der zweiten Außenkontur den kleinsten radialen Abstand (zum Schwenkpunkt S) aufweist.

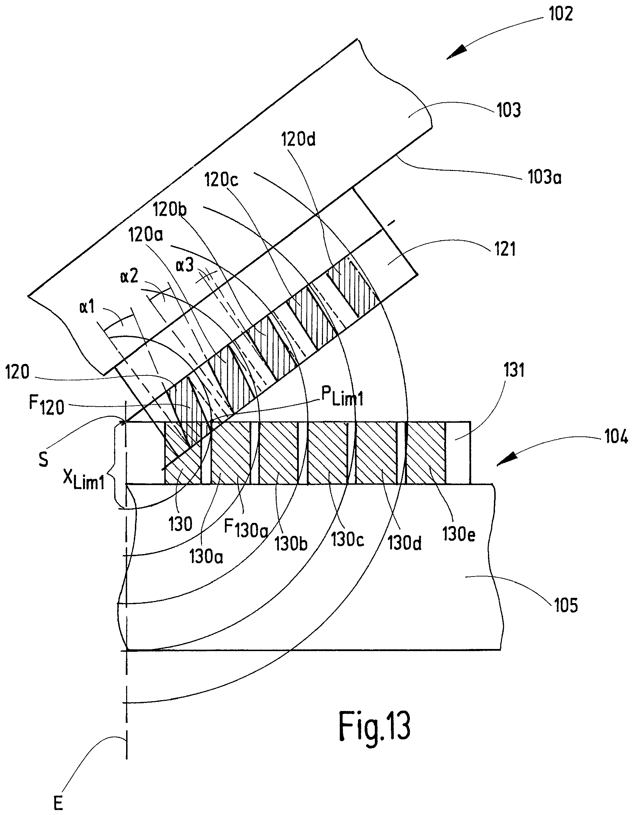

Fig. 13 zeigt eine Querschnittsansicht eines Ausschnitts eines ersten Modulteils 102 und eines zweiten Modulteils 104 nach einem anderen Ausführungsbeispiel, in einem Zustand, in dem das erste Modulteil 102 durch Schwenkbewegung aufgesetzt wird. Die zu dem ersten Ausführungsbeispiel gemachten Ausführungen und Erklärungen treffen ebenfalls auf dieses Ausführungsbeispiels zu. Es verändern sich in dem in Fig. 13 gezeigten Ausführungsbeispiel jedoch die geneigten Abschnitte der Außenkonturen der Kontakte 120, 120a, 120b, 120c, 120d mit zunehmendem radialen Abstand x zwischen Kontakt 120, 120a, 120b, 120c, 120d und dem Schwenkpunkt S. Diese Änderung ist an die Schwenkbewegung angepasst. Genauer gesagt verändern sich die geneigten Abschnitte derart, dass die geneigten Abschnitte bzw. die Außenkonturen an die Schwenkbewegung angepasst sind. In dem Ausführungsbeispiel der Fig. 13 verändert sich der Winkel α₁, α₂, α₃ der geraden geneigten Seiten in Bezug auf die Schwenkachsenebene E mit zunehmendem radialem Abstand x zwischen Kontakt 120, 120a, 120b, 120c, 120d und Schwenkpunkt S. Der Winkel α₁, α₂, α₃ nimmt hier mit zunehmenden radialem Abstand ab. In einem anderen Ausführungsbeispiel kann sich jedoch auch die Außenkontur verändern. Beispielweise kann sich der Radius der in Fig. 12 gezeigten Krümmungen bzw. gekrümmten Seiten mit zunehmendem radialen Abstand x zwischen Kontakt 120, 120a, 120b, 120c, 120d und Schwenkpunkt S verändern (insbesondere abnehmen). Es wird so eine noch genauere Anpassung an die Schwenkbewegung bereitgestellt, da die exakte Position eines jedes Kontaktes in Bezug auf den Schwenkpunkt berücksichtigt wird.

In den oben beschriebenen Ausführungsbeispielen weisen nur die Außenkonturen des Kontakts bzw. der Kontakte 120 einen geneigten Abschnitt auf. Die Außenkonturen des Gegenkontakts bzw. der Gegenkontakte 130 hingegen weisen keinen geneigten Abschnitt auf. Die Gegenkontakte 130 verlaufen in ihrer Längsrichtung parallel zur Schwenkachsenebene E. Somit kann weiterhin ein konventioneller Stecker oder Buchse 131 verwendet werden.

In den oben beschriebenen Ausführungsbeispielen sind das erste Modulteil 102 und das zweite Modulteil 104 jeweils derart ausgebildet, dass ein letzter Kontakt 120d der Anzahl von Kontakten 120, 120a, 120b, 120c, 120d beim Zusammensetzen als letzter Kontakt mit dem entsprechenden Gegenkontakt schließt. Die freiliegenden Kontaktflächen weisen dabei alle denselben Abstand zur Grenzfläche 103a des ersten Modulteils 102 auf. Der letzte Kontakt 120d ist der Kontakt mit dem größten radialen Abstand xₘₐₓ zum Schwenkpunkt S. Es kann so eine bestimmte Schließreihenfolge der Kontakte 120, 120a, 120b, 120c, 120d definiert werden. Es wird erreicht, dass diese Schließreihenfolge durch die definierte Bewegungsbahn der Schwenkbewegung um die Schwenkachse S stets eingehalten wird. Die Steuerungsvorrichtung 1 oder das Modul 100 kann insbesondere einen Ausgang besitzen zum Ausgeben eines Signals, das die Betriebsbereitschaft der Steuerungsvorrichtung 1 oder des Moduls 100 anzeigt, wenn beim Zusammensetzen der letzte Kontakt 120d schließt. Es wird so eine sichere Erkennung des zusammengesetzten (bzw. betriebsbereiten) Zustands des Moduls erreicht, durch Berücksichtigung der bestimmten Schließreihenfolge der Kontakte.

Obwohl vorhergehend der geneigte Abschnitt in Bezug auf die Kontaktierung zwischen dem ersten Modulteil 102 und dem zweiten Modulteil 104 beschrieben worden ist, sollte verstanden werden, dass der geneigte Abschnitt ebenfalls in Bezug auf die Kontaktierung zwischen dem ersten Modulteil 102 und dem dritten Modulteil 106 beschrieben werden kann.

Obwohl vorhergehend der elektrische Kontakt 120 bzw. dessen Außenkontur mit geneigtem Abschnitt als Bestandteil des ersten Modulteils 102 in Form des Elektronikmodulteils beschrieben worden ist, sollte verstanden werden, dass der elektrische Kontakt 120 bzw. dessen Außenkontur mit geneigtem Abschnitt, insbesondere auf einer Leiterplatte wie oben beschreiben, auch auf dem hier beschriebenen zweiten Modulteil 104 in Form des Busmodulteils vorgesehen sein kann. In diesem Fall kann sich der geneigte Abschnitt in dem Bereich (des vorlaufenden Endes) der Außenkontur befinden, der den kleinsten radialen Abstand zum Schwenkpunkt aufweist (obere linke Ecke in den Figuren). Im Allgemeinen sollte verstanden werden, dass eine Prinzipumkehr des oben beschriebenen Gedankens jederzeit möglich ist.

Das erste und zweite Modulteil können durch die Schwenkbewegung entlang der definierten Bewegungsbahn zusammengesetzt werden. Obwohl vorhergehend ein Zusammensetzen bzw. Aufsetzen eines ersten Modulteils 102 durch Schwenkbewegung auf ein statisches (nicht-bewegtes) zweites Modulteil 104 beschreiben worden ist, sollte verstanden werden, dass jede andere Art des Zusammensetzens durch Schwenkbewegung möglich ist. Beispielsweise kann das zweite Modulteil 104 durch Schwenkbewegung auf ein statisches (nicht-bewegtes) erstes Modulteil 102 aufgesetzt werden, oder sowohl das erste Modulteil 102 als auch das zweite Modulteil 104 können durch Schwenkbewegung zueinander hin aufeinander aufgesetzt werden. In diesem Zusammenhang sollte verstanden werden, dass unter vorlaufendem Ende der Außenkontur das Ende der Außenkontur gemeint ist, welches sich, bei Betrachtung einer relativen Bewegungsbahn zwischen erstem Modulteil und zweiten Modulteil, näher zu dem jeweilig anderen Modulteil befindet.

Obwohl vorhergehend eine Steuerungsvorrichtung zum automatisierten Steuern einer technischen Anlage beschrieben worden ist, sollte verstanden werden, dass die Steuerungsvorrichtung auch zum Steuern einer anderen Anwendung verwendet werden kann. Des Weiteren kann die Steuerungsvorrichtung jede andere Vorrichtung sein, in der elektrische Kontakte eines ersten Modulteils und Gegenkontakte eines zweiten Modulteils (durch Schwenkbewegung) zusammengeführt werden.

## Patentansprüche

1. Steuerungsvorrichtung (1) zum automatisierten Steuern einer technischen Anlage, mit zumindest einem Modul (100), das zumindest ein erstes Modulteil (102) und ein zweites Modulteil (104) umfasst, die mechanisch und elektrisch in eine zusammengesetzte Anordnung zusammengesetzt werden können, wobei das erste Modulteil (102) und das zweite Modulteil (104) jeweils ein Gehäuse (103, 105) mit jeweils einer Grenzfläche (103a, 105a) umfassen, wobei sich die Grenzflächen (103a, 105a) in der zusammengesetzten Anordnung derart gegenüberliegen, dass eine Grenzebene (G) definiert ist, wobei das erste Modulteil (102) ein Schwenkhalterungselement (110) aufweist, an dem das zweite Modulteil (104) lösbar gehalten werden kann, wobei das Schwenkhalterungselement (110) einen Schwenkpunkt (S) mit einer Schwenkachse (A) definiert, so dass das erste Modulteil (102) und das zweite Modulteil (104) durch eine Schwenkbewegung entlang einer definierten Bewegungsbahn in die zusammengesetzte Anordnung zusammengesetzt werden können, wobei durch die Schwenkachse (A) eine auf der Schwenkachse (A) liegende, senkrecht zur Grenzebene (G) angeordnete Schwenkachsenebene (E) definiert ist, wobei eines der Modulteile (102) eine Anzahl von Kontakten (120, 120a-d) mit einem ersten elektrischen Kontakt (120) umfasst, und wobei das andere Modulteil (104) eine Anzahl von entsprechenden Gegenkontakten (130, 130a-d) mit einem ersten elektrischen Gegenkontakt (130) umfasst, wobei in der ersten zusammengesetzten Anordnung jeder elektrische Kontakt (120, 120a-d) seinen entsprechenden Gegenkontakt (130, 130a-d) kontaktiert zur elektrischen Verbindung zwischen dem ersten und dem zweiten Modulteil (102, 104), wobei die Kontakte (120, 120a-d) und die Gegenkontakte (130, 130a-d) in einer Kontaktebene, die senkrecht zur Schwenkachse (A) verläuft, angeordnet sind, wobei die Kontakte (120, 120a-d) jeweils eine Leiterbahn auf einer nichtleitenden Platte sind, so dass eine Leiterplatte (121) gebildet wird, **dadurch gekennzeichnet, dass** der erste elektrische Kontakt (120) eine durch eine erste Außenkontur begrenzte freiliegende Kontaktfläche (F₁₂₀) mit einem in der Bewegungsbahn vorlaufendem Ende (127) aufweist, wobei die erste Außenkontur in der zusammengesetzten Anordnung zumindest am vorlaufenden Ende (127) zumindest einen zur Schwenkachsenebene (E) hin geneigten Abschnitt umfasst.

2. Steuerungsvorrichtung nach Anspruch 1, wobei sich der geneigte Abschnitt zumindest in dem Bereich des vorlaufenden Endes der ersten Außenkontur befindet, der den größten radialen Abstand (x) zum Schwenkpunkt (S) aufweist.

3. Steuerungsvorrichtung nach einem der Ansprüche 1 bis 2, wobei der geneigte Abschnitt zumindest eine Gerade oder Krümmung umfasst.

4. Steuerungsvorrichtung nach einem der Ansprüche 1 bis 3, wobei die erste Außenkontur eine vierseitige oder fünfseitige Außenkontur ist.

5. Steuerungsvorrichtung nach Anspruch 3 und 4, wobei der geneigte Abschnitt eine die Gerade umfassende gerade Seite (125) der vierseitigen oder fünfseitigen Außenkontur ist.

6. Steuerungsvorrichtung nach Anspruch 3 und 4, wobei der geneigte Abschnitt eine die Krümmung umfassende gekrümmte Seite (126) der vierseitigen oder fünfseitigen Außenkontur ist.

7. Steuerungsvorrichtung nach einem der Ansprüche 1 bis 6, wobei die erste Kontaktfläche (F₁₂₀) eine Anzahl von voneinander isolierten Kontaktflächen (f₁-f₈) aufweist.

8. Steuerungsvorrichtung nach einem der Ansprüche 1 bis 7, wobei das Modulteil (104) mit dem ersten Gegenkontakt (130) weiterhin einen in auswärtiger radialer Richtung neben dem ersten Gegenkontakt (130) liegenden zweiten elektrischen Gegenkontakt (130a) umfasst, der eine durch eine zweite Außenkontur begrenzte freiliegende Kontaktfläche (F₁₃₀ₐ) aufweist, wobei jeder Punkt der ersten und der zweiten Außenkontur während der Schwenkbewegung einen bestimmten radialen Abstand (x) zum Schwenkpunkt (S) aufweist, und wobei jeder Punkt der ersten Außenkontur einen radialen Abstand (x) aufweist der kleiner ist als ein radialer Abstand (xₗᵢₘ) eines Punktes (Pₗᵢₘ) der zweiten Außenkontur, der von den Punkten der zweiten Außenkontur den kleinsten radialen Abstand aufweist.

9. Steuerungsvorrichtung nach einem der Ansprüche 1 bis 8, wobei sich die geneigten Abschnitte der Außenkonturen der Kontakte (120, 120a-d) mit zunehmendem radialen Abstand (x) zwischen Kontakt (120, 120a-d) und Schwenkpunkt (S) verändern.

10. Steuerungsvorrichtung nach einem der Ansprüche 1 bis 9, wobei das erste Modulteil (102) und das zweite Modulteil (104) derart ausgebildet sind, dass ein letzter Kontakt (120d) der Anzahl von Kontakten (120, 120a-d) beim Zusammensetzen als letzter Kontakt mit dem entsprechenden Gegenkontakt schließt, insbesondere wobei der letzte Kontakt (120d) der Kontakt mit dem größten radialen Abstand (xₘₐₓ) zum Schwenkpunkt (S) ist.

11. Steuerungsvorrichtung nach Anspruch 10, wobei die Steuerungsvorrichtung (1) oder das Modul (100) einen Ausgang besitzt zum Ausgeben eines Signals, das die Betriebsbereitschaft der Steuerungsvorrichtung (1) oder des Moduls (100) anzeigt, wenn beim Zusammensetzen der letzten Kontakt (120d) schließt.

12. Steuerungsvorrichtung nach einem der Ansprüche 1 bis 11, wobei das zweite Modulteil (104) eine Aussparung umfasst, in die das Schwenkhalterungselement (114) des ersten Modulteils (12) eingreifen kann, so dass das zweite Modulteil (102) lösbar gehalten ist.

13. Steuerungsvorrichtung nach einem der Ansprüche 1 bis 12, wobei der erste Gegenkontakt (130) ein Kontaktelement ist, das in einem Stecker oder Buchse (131) angeordnet ist, insbesondere wobei in den Stecker oder Buchse (131) die Leiterplatte (121) eingeführt werden kann.

14. Steuerungsvorrichtung nach einem der Ansprüche 1 bis 13, wobei die Gegenkontakte (130, 130a-d) in ihrer Längsrichtung parallel zur Schwenkachsenebene (E) verlaufen.

15. Erster Modulteil (102) zum Bilden einer zusammengesetzten Anordnung mit einem zweiten Modulteil (104),
mit einem Gehäuse (103), das eine Grenzfläche (103a) aufweist, die in der zusammengesetzten Anordnung einer Grenzfläche (105a) eines Gehäuses (105) des zweiten Modulteils (104) derart gegenüberliegt, dass eine Grenzebene (G) definiert ist,
mit einem Schwenkhalterungselement (110), an dem das zweite Modulteil (104) lösbar gehalten werden kann, und
mit einer Anzahl von Kontakten (120, 120a-d), die einen ersten elektrischen Kontakt (120) umfassen und dazu ausgebildet sind, am zweiten Modulteil (104) eine Anzahl von entsprechenden Gegenkontakten (130, 130a-d) zu kontaktieren, wobei das Schwenkhalterungselement (110) einen Schwenkpunkt (S) mit einer Schwenkachse (A) definiert, so dass das erste Modulteil (102) und das zweite Modulteil (104) durch eine Schwenkbewegung entlang einer definierten Bewegungsbahn in die zusammengesetzte Anordnung zusammengesetzt werden können,
wobei durch die Schwenkachse (A) eine auf der Schwenkachse (A) liegende, senkrecht zur Grenzebene (G) angeordnete Schwenkachsenebene (E) definiert ist,
wobei die Kontakte (120, 120a-d) in einer Kontaktebene, die senkrecht zur Schwenkachse (A) verläuft, angeordnet sind,
wobei die Kontakte (120, 120a-d) jeweils eine Leiterbahn auf einer nichtleitenden Platte sind, so dass eine Leiterplatte (121) gebildet wird,
**dadurch gekennzeichnet, dass**
der erste elektrische Kontakt (120) eine durch eine erste Außenkontur begrenzte freiliegende Kontaktfläche (F₁₂₀) mit einem in der Bewegungsbahn vorlaufendem Ende (127) aufweist, wobei die erste Außenkontur in der zusammengesetzten Anordnung zumindest am vorlaufenden Ende (127) zumindest einen zur Schwenkachsenebene (E) hin geneigten Abschnitt umfasst.

## Claims

1. A control apparatus (1) for the automated control of a technical installation, comprising at least one module (100) having at least a first module part (102) and a second module part (104), which can be mechanically and electrically combined to form a combined arrangement, wherein the first module part (102) and the second module part (104) each comprise a housing (103, 105), each housing having a boundary surface (103a, 105a), wherein the boundary surfaces (103a, 105a) are opposite one another in the combined arrangement such that a boundary plane (G) is defined, wherein the first module part (102) has a pivoting holder element (110) on which the second module part (104) can be detachably held, wherein the pivoting holder element (110) defines a pivot point (S) with a pivot axis (A) such that the first module part (102) and the second module part (104) can be combined by a pivoting movement along a defined movement path to the form the combined arrangement, wherein a pivot axis plane (E) which is arranged on the pivot axis (A) perpendicular to the boundary plane (G) is defined by the pivot axis (A), wherein one of the module parts (102) has a number of contacts (120, 102a-d) with a first electrical contact (120), and wherein the other module part (104) has a number of corresponding mating contacts (130, 130a-d) with a first electrical mating contact (130), wherein, in the first combined arrangement, each electrical contact (120, 120a-d) makes contact with its corresponding mating contact (130, 103a-d) for electrical connection between the first and the second module parts (102, 104), wherein the contacts (120, 120a-d) and the mating contacts (130, 103a-d) are arranged in a contact plane, which is perpendicular to the pivot axis (A), wherein the contacts (120, 120a-d) are each conductor tracks on a nonconductive board such that a printed circuit board (121) is formed, **characterized in that** the first electrical contact (120) has an exposed contact area (F₁₂₀) defined by a first outer contour and comprising a leading end (127) with respect to the movement path, wherein the first outer contour, in the combined arrangement, comprises at least one section which is inclined towards the pivot axis plane (E) at least at the leading end (127).

2. The control apparatus of claim 1, wherein the inclined section is located at least in the region of the leading end of the first outer contour which has the greatest radial distance (x) from the pivot point (S).

3. The control apparatus according to any one of claims 1 to 2, wherein the inclined section comprises at least one straight line or curvature.

4. The control apparatus according to any one of claims 1 to 3, wherein the first outer contour is a four-sided or five-sided outer contour.

5. The control apparatus according to claims 3 and 4, wherein the inclined section is a straight side (125), comprising the straight line, of the four-sided or five-sided outer contour.

6. The control apparatus according to claims 3 and 4, wherein the inclined section is a curved side (126), comprising the curvature, of the four-sided or five-sided outer contour.

7. The control apparatus according to any one of claims 1 to 6, wherein the first contact area (F₁₂₀) comprises a number of contact areas (f₁-f₈) which are insulated from one another.

8. The control apparatus according to any one of claims 1 to 7, wherein the module part (104) with the first mating contact (130) further comprises a second electrical mating contact (130a), which is next to the first mating contact (130) in the outward radial direction and has an exposed contact area (F130a) which is delimited by a second outer contour, wherein each point on the first and second outer contours has a certain radial distance (x) from the pivot point (S) during the pivoting movement, and wherein each point on the first outer contour has a radial distance (x) which is smaller than a radial distance (xₗᵢₘ) of a point (Pₗᵢₘ) on the second outer contour which has the smallest radial distance of the points on the second outer contour.

9. The control apparatus according to any one of claims 1 to 8, wherein the inclined sections of the outer contours of the contacts (120, 120a-d) differ as the radial distance (x) between the contact (120, 120a-d) and the pivot point (S) increases.

10. The control apparatus according to any one of claims 1 to 9, wherein the first module part (102) and the second module part (104) are designed in such a manner that a last contact (120d) of the number of contacts (120, 120a-d) closes at last with the corresponding mating contact in the pivoting movement, wherein, in particular, the last contact (120d) is the contact with the greatest radial distance (xₘₐₓ) from the pivot point (S).

11. The control apparatus of claim 10, wherein the control apparatus (1) or the module (100) has an output for outputting a signal, which indicates the operational readiness of the control apparatus (1) or the module (100) when, during assembly, the last contact (120d) closes.

12. The control apparatus according to any one of claims 1 to 11, wherein the second module part (104) comprises a cutout, into which the pivoting holder element (114) of the first module part (12) can engage such that the second module part (102) is detachably held.

13. The control apparatus according to any one of claims 1 to 12, wherein the first mating contact (130) is contact element, which is arranged in a plug or a socket (131), in particular, wherein into the plug or the socket (131) the circuit board (121) can be inserted.

14. The control apparatus according to any one of the claims 1 to 13, wherein the mating contacts (130, 130a-d) are lengthways parallel to the pivot axis plane (E).

15. A first module part (102) for forming a combined arrangement with a second module part (104), comprising a housing (103) having a boundary surface (103a), which, in the combined arrangement, is being opposite to a boundary surface (105a) of a housing (105) of the second module part (104) such that a boundary plane (G) is defined, a pivoting holder element (110), on which the second module part (104) can be detachably held, and a number of contacts (120, 120a-d) having a first electrical contact (120) and being configured to contact a number of mating contacts (130, 130a-d) on the second module part (104), wherein the pivoting holding element (110) defines a pivot point (S) with a pivot axis (A) such that the first module part (102) and the second module part (104) can be combined into the combined arrangement by a pivoting movement along a defined movement path, wherein a pivot axis plane (E), which is arranged on the pivot axis (A) perpendicular to the boundary plane (G), is defined by the pivot axis (A), wherein the contacts (120, 120a-d) are arranged in a contact plane, which is perpendicular to the pivot axis (A), wherein the contacts (120, 120a-d) are each conductor tracks on a nonconductive board such that a printed circuit board (121) is formed, **characterized in that** the first electrical contact (120) has an exposed contact area (F₁₂₀) defined by a first outer contour and comprising a leading end (127) with respect to the movement path, wherein the first outer contour, in the combined arrangement, comprises at least one section which is inclined towards the pivot axis plane (E) at least at the leading end (127).

## Revendications

1. Dispositif de commande (1) destiné à la commande automatisée d'un équipement technique, comprenant au moins un module (100) qui comporte au moins une première partie de module (102) et une deuxième partie de module (104), lesquels peuvent être assemblés mécaniquement et électriquement en une disposition assemblée, la première partie de module (102) et la deuxième partie de module (104) comportant respectivement un boîtier (103, 105) ayant respectivement une surface limite (103a, 105a), les surfaces limites (103a, 105a) se trouvant opposées dans la disposition assemblée de telle sorte qu'un plan de délimitation (G) est défini, la première partie de module (102) possédant un élément de maintien pivotant (110) auquel la deuxième partie de module (104) peut être maintenue de manière amovible, l'élément de maintien pivotant (110) définissant un point de pivotement (S) avec un axe de pivotement (A), de sorte que la première partie de module (102) et la deuxième partie de module (104) peuvent être assemblées dans la disposition assemblée par un mouvement de pivotement le long d'une trajectoire de mouvement définie, un plan d'axe de pivotement (E) reposant sur l'axe de pivotement (A) et perpendiculaire au plan de délimitation (G) étant défini par l'axe de pivotement (A), l'une des parties de module (102) comportant une pluralité de contacts (120, 120a-d) avec un premier contact électrique (120), et l'autre partie de module (104) comportant une pluralité de contacts homologues (130, 130a-d) correspondants avec un premier contact homologue électrique (130), chaque contact électrique (120, 120a-d), dans la première disposition assemblée, établissant le contact avec son contact homologue (130, 130a-d) correspondant en vue d'une liaison électrique entre la première et la deuxième partie de module (102, 104), les contacts (120, 120a-d) et les contacts homologues (130, 130a-d) étant disposés dans un plan de contact qui s'étend perpendiculairement à l'axe de pivotement (A), les contacts (120, 120a-d) étant respectivement une piste conductrice sur une plaque non conductrice, de sorte qu'un circuit imprimé (121) est formé, **caractérisé en ce que** le premier contact électrique (120) possède une surface de contact (F₁₂₀) dégagée délimitée par un premier contour extérieur et ayant une extrémité (127) en avance dans la trajectoire de mouvement, le premier contour extérieur dans la disposition assemblée comportant au moins une portion inclinée vers le plan d'axe de pivotement (E) au moins au niveau de l'extrémité (127) en avance.

2. Dispositif de commande selon la revendication 1, la portion inclinée se trouvant au moins dans la zone de l'extrémité en avance du premier contour extérieur qui présente le plus grand écart radial (x) par rapport au point de pivotement (S).

3. Dispositif de commande selon l'une des revendications 1 à 2, la portion inclinée comportant au moins une droite ou une courbe.

4. Dispositif de commande selon l'une des revendications 1 à 3, le premier contour extérieur étant un contour extérieur quadrilatéral ou pentagonal.

5. Dispositif de commande selon les revendications 3 et 4, la portion inclinée étant le côté droit (125) comportant la droite du contour extérieur quadrilatéral ou pentagonal.

6. Dispositif de commande selon les revendications 3 et 4, la portion inclinée étant le côté courbé (126) comportant la courbe du contour extérieur quadrilatéral ou pentagonal.

7. Dispositif de commande selon l'une des revendications 1 à 6, la première surface de contact (F₁₂₀) possédant une pluralité de surfaces de contact (f₁-f₈) isolées les unes des autres.

8. Dispositif de commande selon l'une des revendications 1 à 7, la partie de module (104) munie du premier contact homologue (130) comportant en outre un deuxième contact homologue électrique (130a) qui se trouve dans la direction radiale vers l'extérieur à côté du premier contact homologue (130), lequel possède une surface de contact (F₁₃₀ₐ) dégagée délimitée par un deuxième contour extérieur, chaque point du premier et du deuxième contour extérieur possédant un écart radial (x) donné par rapport au point de pivotement (S) pendant le mouvement de pivotement, et chaque point du premier contour extérieur possédant un écart radial (x) qui est inférieur à un écart radial (xₗᵢₘ) d'un point (Pₗᵢₘ) du deuxième contour extérieur qui présent le plus petit écart radial des points du deuxième contour extérieur.

9. Dispositif de commande selon l'une des revendications 1 à 8, les portions inclinées des contours extérieurs des contacts (120, 120a-d) variant à mesure que l'écart radial (x) entre le contact (120, 120a-d) et le point de pivotement (S) augmente.

10. Dispositif de commande selon l'une des revendications 1 à 9, la première partie de module (102) et la deuxième partie de module (104) étant configurées de telle sorte qu'un dernier contact (120d) de la pluralité de contacts (120, 120a-d) se ferme en tant que dernier contact au contact homologue correspondant lors de l'assemblage, le dernier contact (120d) étant notamment le contact ayant l'écart radial le plus grand (xₘₐₓ) par rapport au point de pivotement (S).

11. Dispositif de commande selon la revendication 10, le dispositif de commande (1) ou le module (100) possédant une sortie pour délivrer un signal qui indique l'état prêt à fonctionner du dispositif de commande (1) ou du module (100) lorsque le dernier contact (120d) se ferme lors de l'assemblage.

12. Dispositif de commande selon l'une des revendications 1 à 11, la deuxième partie de module (104) comportant une cavité dans laquelle peut venir en prise l'élément de maintien pivotant (114) de la première partie de module (12), de sorte que la deuxième partie de module (102) est maintenue de manière amovible.

13. Dispositif de commande selon l'une des revendications 1 à 12, le premier contact homologue (130) étant un élément de contact qui est disposé dans une fiche ou une douille (131), le circuit imprimé (121) pouvant notamment être inséré dans la fiche ou la douille (131).

14. Dispositif de commande selon l'une des revendications 1 à 13, les contacts homologues (130, 130a-d) s'étendant parallèlement au plan d'axe de pivotement (E) dans leur direction longitudinale.

15. Première partie de module (102) destinée à former une disposition assemblée avec une deuxième partie de module (104),
comprenant un boîtier (103) qui possède une surface limite (103a) qui, dans la disposition assemblée, se trouve opposée à une surface limite (105a) d'un boîtier (105) du deuxième partie de module (104) de telle sorte qu'un plan de délimitation (G) est défini,
comprenant un élément de maintien pivotant (110) auquel la deuxième partie de module (104) peut être maintenue de manière amovible, et
comprenant une pluralité de contacts (120, 120a-d) qui comportent un premier contact électrique (120) et qui sont configurés pour établir le contact avec une pluralité de contacts homologues (130, 130a-d) correspondants sur la deuxième partie de module (104),
l'élément de maintien pivotant (110) définissant un point de pivotement (S) avec un axe de pivotement (A), de sorte que la première partie de module (102) et la deuxième partie de module (104) peuvent être assemblées dans la disposition assemblée par un mouvement de pivotement le long d'une trajectoire de mouvement définie,
un plan d'axe de pivotement (E) reposant sur l'axe de pivotement (A) et perpendiculaire au plan de délimitation (G) étant défini par l'axe de pivotement (A),
les contacts (120, 120a-d) étant disposés dans un plan de contact qui s'étend perpendiculairement à l'axe de pivotement (A),
les contacts (120, 120a-d) étant respectivement une piste conductrice sur une plaque non conductrice, de sorte qu'un circuit imprimé (121) est formé,
**caractérisé en ce que**
le premier contact électrique (120) possède une surface de contact (F₁₂₀) dégagée délimitée par un premier contour extérieur et ayant une extrémité (127) en avance dans la trajectoire de mouvement, le premier contour extérieur dans la disposition assemblée comportant au moins une portion inclinée vers le plan d'axe de pivotement (E) au moins au niveau de l'extrémité (127) en avance.
